(19) Europäisches Patentamt
European Patent Office
Office européen des brevets

(11) EP 4 485 075 A1

(12) EUROPEAN PATENT APPLICATION

(43) Date of publication:
01.01.2025 Bulletin 2025/01

(21) Application number: 24164779.1

(22) Date of filing: 20.03.2024

(51) International Patent Classification (IPC):
*G03F 7/004* (2006.01) *G03F 7/039* (2006.01)

(52) Cooperative Patent Classification (CPC):
(C-Sets available)
**G03F 7/004; C08F 212/22; C08F 212/24; C09D 125/06; G03F 7/0397** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.06.2023 KR 20230084525**
**16.11.2023 KR 20230159280**

(71) Applicant: **Samsung Electronics Co., Ltd.**
**Suwon-si, Gyeonggi-do 16677 (KR)**

(72) Inventors:
- **KIM, Beomseok**
  **16678 Suwon-si (KR)**
- **KIM, Minsang**
  **16678 Suwon-si (KR)**
- **KOH, Haengdeog**
  **16678 Suwon-si (KR)**
- **KWAK, Yoonhyun**
  **16678 Suwon-si (KR)**
- **AHN, Chanjae**
  **16678 Suwon-si (KR)**
- **LEE, Changheon**
  **16678 Suwon-si (KR)**
- **IM, Kyuhyun**
  **16678 Suwon-si (KR)**
- **CHOI, Sungwon**
  **16678 Suwon-si (KR)**

(74) Representative: **Elkington and Fife LLP**
**Prospect House**
**8 Pembroke Road**
**Sevenoaks, Kent TN13 1XR (GB)**

(54) **POLYMER, RESIST COMPOSITION INCLUDING THE SAME, AND METHOD OF FORMING PATTERN BY USING THE RESIST COMPOSITION**

(57) Provided are a polymer including a first repeating unit represented by Formula 1, a resist composition including the polymer, and a method of forming a pattern using the resist composition:

EP 4 485 075 A1

Formula 1

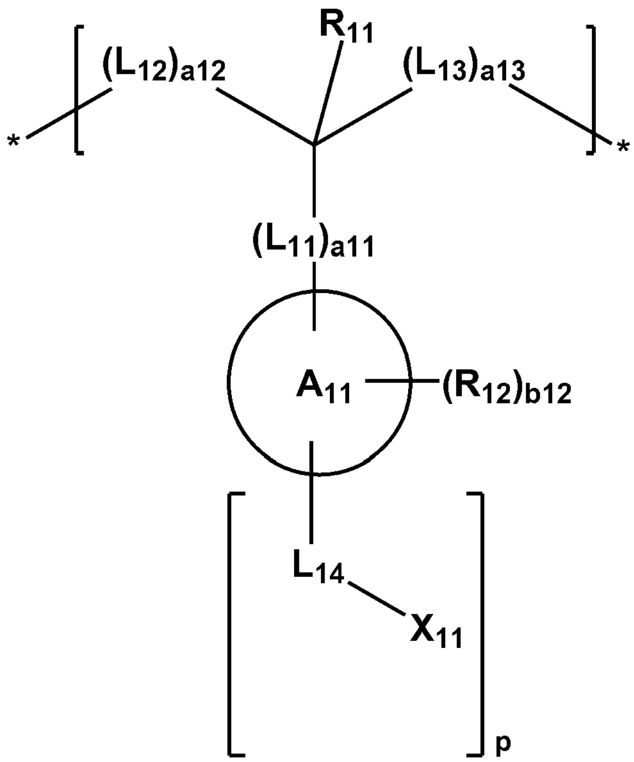

wherein descriptions of $L_{11}$ to $L_{14}$, a11 to a13, $A_{11}$, $X_{11}$, $R_{11}$, $R_{12}$, b12 and p in Formula 1 are provided in the present specification.

# FIG. 1

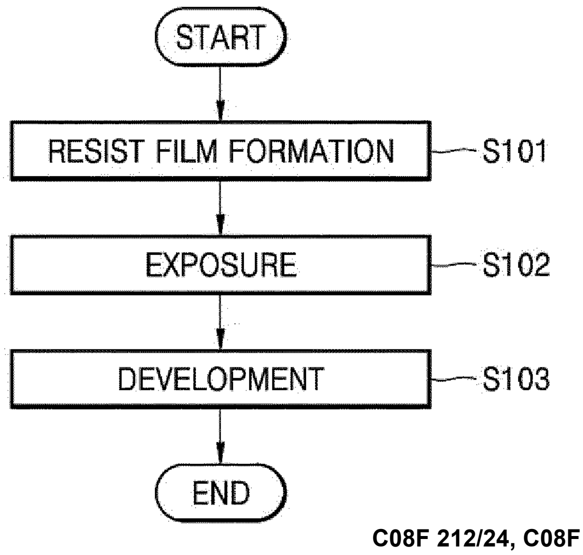


(52) Cooperative Patent Classification (CPC): (Cont.)

C-Sets
**C08F 212/22, C08F 212/24;**
**C08F 212/22, C08F 212/24, C08F 220/1807;**
**C08F 212/24, C08F 212/22;**
**C08F 212/24, C08F 212/22, C08F 220/1807;**
**C09D 125/06, C08K 5/36**

**Description**

FIELD OF THE INVENTION

The disclosure relates to a polymer, a resist composition including the same, and a method of forming a pattern by using the resist composition.

BACKGROUND OF THE INVENTION

In semiconductor manufacturing, resists of which physical properties change in response to light are used to form fine patterns. From among these resists, a chemically amplified resist has been widely used. A chemically amplified resist enables patterning by changing the solubility of a base resin in a developer by reacting an acid, which has been formed by a reaction between light and a photoacid generator, with the base resin again.

In particular, in the case of using high-energy rays having relatively very high energy, such as EUV rays, the number of photons may be remarkably small even when light having the same energy is irradiated. Accordingly, there may be a demand for a resist composition that can act effectively even when a small amount is used and that can provide improved sensitivity and/or resolution.

SUMMARY OF THE INVENTION

Provided are a polymer capable of providing improved sensitivity and/or improved resolution, a resist composition including the polymer, and a method of forming a pattern by using the resist composition.

Additional aspects will be set forth in part in the description which follows and, in part, will be apparent from the description, or may be learned by practice of the presented embodiments of the disclosure.

According to an embodiment of the disclosure, a polymer may include a first repeating unit represented by Formula 1:

Formula 1

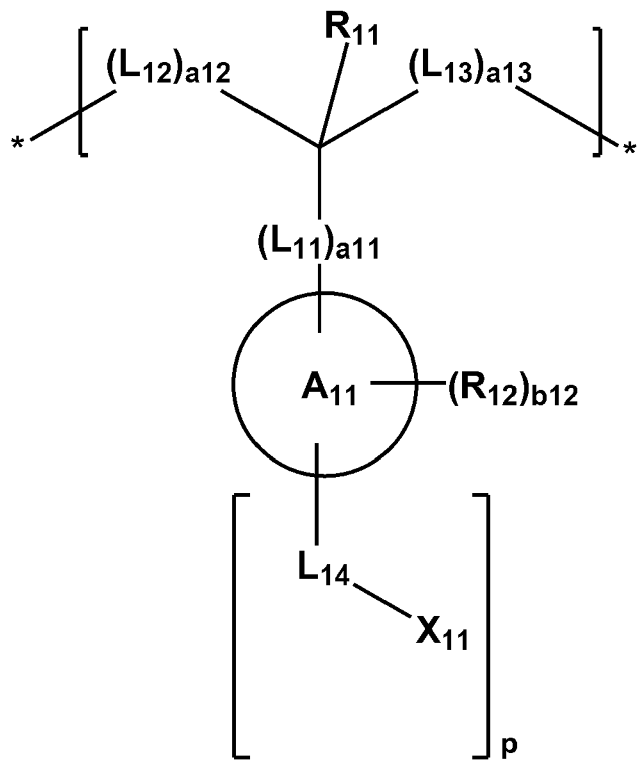

wherein, in Formula 1,

$L_{11}$ to $L_{13}$ may each independently be a single bond, O, S, C(=O), C(=O)O, OC(=O), C(=O)NH, NHC(=O), or a linear, branched, or cyclic $C_1$-$C_{30}$ divalent hydrocarbon group that optionally includes a heteroatom,

$L_{14}$ may be a linear, branched, or cyclic $C_1$-$C_{30}$ monovalent hydrocarbon group that optionally includes a heteroatom,
a11 to a13 may each independently be an integer from 1 to 4,
$A_{11}$ may be a $C_6$-$C_{30}$ aromatic group or a $C_1$-$C_{30}$ heteroaromatic group,
$R_{11}$ and $R_{12}$ may each independently be hydrogen, deuterium, a halogen, a cyano group, a hydroxy group, an amino group, a carboxylic acid group, a thiol group, an ester moiety, a sulfonate ester moiety, a carbonate moiety, a lactone moiety, a sultone moiety, a carboxylic anhydride moiety, or a linear, branched, or cyclic $C_1$-$C_{30}$ monovalent hydrocarbon group that optionally includes a heteroatom,
b12 may be an integer from1 to 10,
$X_{11}$ may be OH, SH, or $NH_2$,
p may be an integer from 1 to 5, and
* indicates a binding site to a neighboring atom.

According to an embodiment of the disclosure, a resist composition may include the polymer, a photoacid generator, and an organic solvent.
According to an embodiment of the disclosure, a method of forming a pattern may include forming a resist film by applying the photoresist composition, exposing at least a portion of the resist film to high-energy rays to provide an exposed resist film, and developing the exposed resist film by using a developer.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a flowchart representing a pattern formation method according to an embodiment;
FIGS. 2A to 2C are each a side cross-sectional view illustrating a pattern formation method according to an embodiment;
FIGS. 3A to 3J each show a graph of normalized residual film thickness according to an exposure level evaluated in Evaluation Example 1;
FIGS. 4A to 4E are side cross-sectional views illustrating a method of forming a patterned structure according to an embodiment; and
FIGS. 5A to 5E are side cross-sectional views illustrating a method of forming a semiconductor device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figure, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.
When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.
Terms such as "first", "second", "third", and the like may be used to describe various components, but are used only for the purpose of distinguishing one component from other components, and the order, type, and the like of the components are not limited.
It will be understood that when a component, such as a layer, a film, a region, or a plate, is referred to as being "on" or "above" another component in the specification, the component can directly contact to be above, below, right, or left of the another component as well as being above, below, left, or right of the another component in a non-contact manner.
An expression used in the singular encompasses the expression of the plural, unless it has a clearly different

meaning in the context. It is to be understood that the terms such as "including," "having," and "comprising" are intended to indicate the existence of the features, numbers, steps, actions, components, parts, ingredients, materials, or combinations thereof disclosed in the specification, and are not intended to preclude the possibility that one or more other features, numbers, steps, actions, components, parts, ingredients, materials, or combinations thereof may exist or may be added.

Whenever a range of values is enumerated, the range includes all values within the range as if recorded explicitly clearly, and may further include the boundaries of the range. Accordingly, the expression in a range of "X" to "Y" includes all values between X and Y, including X and Y.

The term "$C_x$-$C_y$" as used herein refers to a case where the number of carbons constituting the substituent is x to y. For example, the term "$C_1$-$C_6$" refers to a case where the number of carbons constituting the substituent is 1 to 6, and the term "$C_6$-$C_{20}$" refers to a case where the number of carbons constituting the substituent is 6 to 20.

The term "monovalent hydrocarbon group" as used herein refers to a monovalent residue derived from an organic compound including carbon and hydrogen or a derivative of the organic compound, and examples thereof may include: a linear or branched alkyl group (e.g., a methyl group, an ethyl group, a propyl group, an isopropyl group, a butyl group, an isobutyl group, a sec-butyl group, a tert-butyl group, a pentyl group, a neopentyl group, a hexyl group, a heptyl group, a 2-ethylhexyl group, and a nonyl group); a monovalent saturated cyclic aliphatic hydrocarbon group (i.e., a cycloalkyl group) (e.g., a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a 1-adamantyl group, a 2-adamantyl group, a 1-adamantylmethyl group, a norbornyl group, a norbornylmethyl group, a tricyclodecanyl group, a tetracyclododecanyl group, a tetracyclododecanylmethyl group, and a dicyclohexylmethyl group); a monovalent unsaturated aliphatic hydrocarbon group (e.g., an alkenyl group, an alkynyl group, and an allyl group); a monovalent unsaturated cyclic aliphatic hydrocarbon group (e.g., a cycloalkenyl group and a 3-cyclohexenyl group); an aryl group (e.g., a phenyl group, a 1-napthyl group, and a 2-napthyl group); an arylalkyl group (e.g., a benzyl group and a diphenylmethyl group); a heteroatom-containing monovalent hydrocarbon group (e.g., a tetrahydrofuranyl group, a methoxymethyl group, an ethoxy methyl group, a methylthiomethyl group, an acetamidemethyl group, a trifluoroethyl group, a (2-methoxyethoxy)methyl group, an acetoxymethyl group, a 2-carboxyl-1-cyclohexyl group, a 2-oxopropyl group, a 4-oxo-1-adamantyl group, and a 3-oxocyclohexyl group); or any combination thereof. In addition, among these groups, some hydrogen atoms may be substituted with a moiety including a heteroatom, such as oxygen, sulfur, nitrogen, or a halogen atom, or some carbon atoms may be replaced by a moiety including a heteroatom, such as oxygen, sulfur, or nitrogen. Accordingly, these groups may each include a hydroxy group, a cyano group, a carbonyl group, a carboxyl group, an ether linkage, an ester linkage, a sulfonate ester linkage, a carbonate, a lactone ring, a sultone ring, a carboxylic anhydride moiety, or a haloalkyl moiety.

The term "divalent hydrocarbon group" as used herein refers to a divalent residue in which one hydrogen of the monovalent hydrocarbon group is replaced by a binding site to a neighboring atom. Examples of the divalent hydrocarbon group may include a linear or branched alkylene group, a cycloalkylene group, an alkenylene group, an alkynylene group, a cycloalkylene group, an arylene group, or a group in which some carbon atoms are replaced by a heteroatom.

The term "alkyl group" as used herein refers to a linear or branched saturated aliphatic hydrocarbon monovalent group, and examples thereof may include a methyl group, an ethyl group, a propyl group, an isobutyl group, a sec-butyl group, a ter-butyl group, a pentyl group, an iso-amyl group, a hexyl group, and the like. The term "alkylene group" as used herein refers to a linear or branched saturated aliphatic divalent hydrocarbon group, and examples thereof may include a methylene group, an ethylene group, a propylene group, a butylene group, an isobutyl group, and the like.

The term "halogenated alkyl group" as used herein refers to a group in which one or more hydrogen atoms of an alkyl group are substituted with halogen, and examples include may include $CF_3$ and the like.

The term "alkoxy group" as used herein refers to a monovalent group represented by - $OA_{101}$, wherein $A_{101}$ is an alkyl group. Examples thereof may include a methoxy group, an ethoxy group, an isopropyloxy group, and the like.

The term "alkylthio group" as used herein refers to a monovalent group represented by $-SA_{101}$, wherein $A_{101}$ is an alkyl group.

The term "halogenated alkyl group" as used herein refers to a group in which one or more hydrogen atoms of an alkoxy group are substituted with halogen, and examples thereof may include $-OCF_3$ and the like.

The term "halogenated alkylthio group" as used herein refers to a group in which one or more hydrogen atoms of an alkylthio group are substituted with halogen, and examples thereof may include $-SCF_3$ and the like.

The term "cycloalkyl group" as used herein refers to a monovalent saturated hydrocarbon cyclic group, and examples thereof may include a monocyclic group, such as a cyclopropyl group, a cyclobutyl group, a cyclopentyl group, a cyclohexyl group, a cycloheptyl group, and the like, and a polycyclic condensed group, such as a norbornyl group and an adamantyl group. The term "cycloalkylene group" used herein refers to a divalent saturated hydrocarbon cyclic group, and examples thereof include a cyclopentylene group, a cyclohexylene group, an adamantylene group, an adamantylmethylene group, a norbomylene group, a norbornylmethylene group, a tricyclodecanylene group, a tetracyclododecanylene group, a tetracyclododecanylmethylene group, a dicyclohexylmethylene group, and the like.

The term "cycloalkoxy group" as used herein refers to a monovalent group represented by $-OA_{102}$, wherein $A_{102}$

is a cycloalkyl group. Examples thereof may include a cyclopropoxy group, a cyclobutoxy group, and the like.

The term "cycloalkylthio group" as used herein refers to a monovalent group represented by $-SA_{102}$, wherein $A_{102}$ is a cycloalkyl group.

The term "heterocycloalkyl group" as used herein refers to a group in which some carbon atoms of the cycloalkyl group are replaced by a moiety including a heteroatom, such as oxygen, sulfur, or nitrogen, and examples of the heterocycloalkyl group include an ether linkage, an ester linkage, a sulfonic ester linkage, a carbonate, a lactone ring, a sultone ring, or a carboxylic anhydride moiety. The term "heterocycloalkylene group" as used herein refers to a group in which some carbon atoms of the cycloalkylene group are replaced by a moiety including a heteroatom, such as oxygen, sulfur, or nitrogen.

The term "heterocycloalkoxy group" as used herein refers to a monovalent group represented by $-OA_{103}$, wherein $A_{103}$ is a heterocycloalkyl group.

The term "alkenyl group" as used herein refers to a linear or branched unsaturated aliphatic monovalent hydrocarbon including one or more carbon-carbon double bond. The term "alkenylene group" as used herein refers to a linear or branched unsaturated aliphatic divalent hydrocarbon including one or more carbon-carbon double bonds.

The term "alkenyloxy group" as used herein refers to a monovalent group represented by $-OA_{104}$, wherein $A_{104}$ is an alkenyl group.

The term "cycloalkenyl group" as used herein refers to a monovalent unsaturated cyclic hydrocarbon group including one or more carbon-carbon double bonds. The term "cycloalkenylene group" as used herein refers to a divalent unsaturated cyclic hydrocarbon group including one or more carbon-carbon double bonds.

The term "cycloalkenyloxy group" as used herein refers to a monovalent group represented by $-OA_{105}$, wherein $A_{105}$ is an alkenyl group.

The term "heterocycloalkenyl group" as used herein refers to a group in which some carbon atoms of the cycloalkenylene group are replaced by a moiety including a heteroatom, such as oxygen, sulfur, or nitrogen. The term "heterocycloalkenylene group" as used herein refers to a group in which some carbon atoms of the cycloalkenylene group are replaced by a moiety including a heteroatom, such as oxygen, sulfur, or nitrogen.

The term "heterocycloalkenyloxy group" as used herein refers to a monovalent group represented by $-OA_{106}$, wherein $A_{106}$ is a heterocycloalkenyl group.

The term "alkynyl group" as used herein refers to a linear or branched unsaturated aliphatic monovalent hydrocarbon including one or more carbon-carbon triple bonds.

The term "alkynyloxy group" as used herein refers to a monovalent group represented by $-OA_{107}$, wherein $A_{107}$ is an alkenyl group.

The term "aryl group" as used herein refers to a monovalent group having a carbocyclic aromatic system, and examples thereof may include a phenyl group, a naphthyl group, an anthracenyl group, a phenanthrenyl group, a pyrenyl group, a chrysenyl group, and the like.

The term "aryloxy group" as used herein refers to a monovalent group represented by $-OA_{108}$, wherein $A_{108}$ is an alkyl group.

The term "heteroaryl group" as used herein refers to a monovalent group having a heterocyclic aromatic system, and examples thereof may include a pyridinyl group, a pyrimidinyl group, a pyrazinyl group, and the like. The term "heteroarylene group" as used herein refers to a divalent group having a heterocyclic aromatic system.

The term "heteroaryloxy group" as used herein refers to a monovalent group represented by $-OA_{109}$, wherein $A_{109}$ is a heteroaryl group.

The term "substituent" as used herein may include: deuterium, a halogen, a hydroxyl group, a cyano group, a nitro group, a carbonyl group, a carboxylic acid group, an amino group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio, a $C_1$-$C_{20}$ halogenated alkoxy group, a $C_1$-$C_{20}$ halogenated alkylthio, a $C_3$-$C_{20}$ cycloalkyl group, a $C_3$-$C_{20}$ cycloalkoxy group, a $C_3$-$C_{20}$ cycloalkylthio, a $C_6$-$C_{20}$ aryl group, a $C_6$-$C_{20}$ aryloxy group, a $C_6$-$C_{20}$ arylthio, a $C_1$-$C_{20}$ heteroaryl group, a $C_1$-$C_{20}$ heteroaryloxy group, or a $C_1$-$C_{20}$ heteroarylthio group;

a $C_1$-$C_{20}$ alkyl group, a $C_1$-$C_{20}$ halogenated alkyl group, a $C_1$-$C_{20}$ alkoxy group, a $C_1$-$C_{20}$ alkylthio, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group, a $C_1$-$C_{20}$ heteroaryl group, a $C_1$-$C_{20}$ heteroaryloxy group, or a $C_1$-$C_{20}$ heteroarylthio, each substituted with deuterium, a halogen, a hydroxyl group, a cyano group, a nitro group, a carbonyl group, a carboxylic acid group, an amino group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group, a $C_1$-$C_{20}$ heteroaryl group, a $C_1$-$C_{20}$ heteroaryloxy group, a $C_1$-$C_{20}$ heteroarylthio group, or any combination thereof; and any combination

thereof.

Hereinafter, the disclosure will be described in detail by explaining embodiments with reference to the accompanying drawings, and substantially identical or corresponding components are given the same reference numerals in the drawings, and thus a description thereof will be omitted. Regarding the drawings, the thickness is shown enlarged to clearly express the various layers and regions. Also, in the drawings, the thicknesses of some layers and regions are exaggerated for convenience of description. Meanwhile, embodiments described below are illustrative examples of embodiments, and various changes in forms and details may be made.

[Polymer]

A polymer according to an embodiment may include a first repeating unit represented by Formula 1:

Formula 1

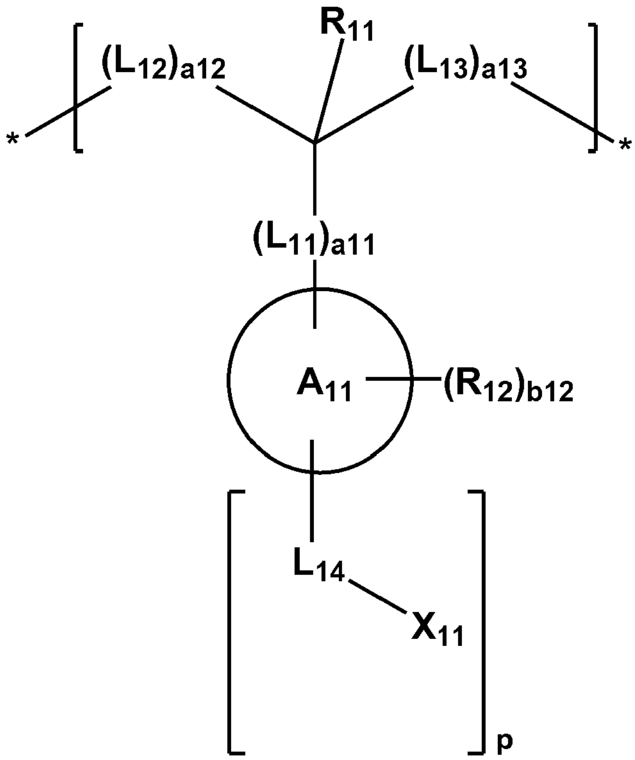

wherein, in Formula 1,

$L_{11}$ to $L_{13}$ may each independently be: a single bond; O; S; C(=O); C(=O)O; OC(=O); C(=O)NH; NHC(=O); or a linear, branched, or cyclic $C_1$-$C_{30}$ divalent hydrocarbon group that optionally includes a heteroatom,
$L_{14}$ may be a linear, branched, or cyclic $C_1$-$C_{30}$ monovalent hydrocarbon group that optionally includes a heteroatom,
a11 to a13 may each independently be an integer from 1 to 4,
$A_{11}$ may be a $C_6$-$C_{30}$ aromatic group or a $C_1$-$C_{30}$ heteroaromatic group,
$R_{11}$ and $R_{12}$ may each independently be: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{30}$ monovalent hydrocarbon group that optionally includes a heteroatom,
b12 may be an integer from 1 to 10,
$X_{11}$ may be OH, SH, or $NH_2$,
p may be an integer from 1 to 5, and
* indicates a binding site to a neighboring atom.

In an embodiment, $L_{11}$ to $L_{13}$ in Formula 1 may each independently be: a single bond; O; S; C(=O); C(=O)O; OC(=O); C(=O)NH; NHC(=O); a substituted or unsubstituted $C_1$-$C_{30}$ alkylene group; a substituted or unsubstituted $C_3$-$C_{30}$ cycloalkylene group; a substituted or unsubstituted $C_3$-$C_{30}$ heterocycloalkylene group; a substituted or unsubstituted

$C_2$-$C_{30}$ alkenylene group; a substituted or unsubstituted $C_3$-$C_{30}$ cycloalkenylene group; a substituted or unsubstituted $C_3$-$C_{30}$ heterocycloalkenylene group; a substituted or unsubstituted $C_6$-$C_{30}$ arylene group; or a substituted or unsubstituted $C_1$-$C_{30}$ heteroarylene group.

In an embodiment, $L_{11}$ to $L_{13}$ in Formula 1 may each independently be: a single bond; O; C(=O); C(=O)O; OC(=O); and a $C_1$-$C_{20}$ alkylene group, a $C_3$-$C_{20}$ cycloalkylene group, a $C_3$-$C_{20}$ heterocycloalkylene group, a $C_2$-$C_{20}$ alkenylene group, a $C_3$-$C_{20}$ cycloalkenylene group, a $C_3$-$C_{20}$ heterocycloalkenylene group, a $C_6$-$C_{20}$ arylene group, and a $C_1$-$C_{20}$ heteroarylene group, each unsubstituted or substituted with deuterium, a halogen, a cyano group, a hydroxy group, an amino group, a carboxylic acid group, a thiol group, an ester moiety, a sulfonate ester moiety, a carbonate moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_3$-$C_{20}$ cycloalkyl group, a $C_3$-$C_{20}$ cycloalkoxy group, a $C_6$-$C_{20}$ aryl group, or any combination thereof.

In an embodiment, $L_{11}$ to $L_{13}$ in Formula 1 may each independently be: a single bond; O; C(=O); C(=O)O; OC(=O); and a $C_1$-$C_{20}$ alkylene group, a $C_3$-$C_{20}$ cycloalkylene group, a $C_3$-$C_{20}$ heterocycloalkylene group, a phenylene group, and a naphthylene group, each unsubstituted or substituted with deuterium, a halogen, a $C_1$-$C_{20}$ alkyl group, a $C_1$-$C_{20}$ halogenated alkyl group, a $C_1$-$C_{20}$ alkoxy group, a phenyl group, a naphthyl group, or any combination thereof.

In an embodiment, $L_{14}$ in Formula 1 may be: a substituted or unsubstituted $C_1$-$C_{30}$ alkylene group; a substituted or unsubstituted $C_3$-$C_{30}$ cycloalkylene group; a substituted or unsubstituted $C_3$-$C_{30}$ heterocycloalkylene group; a substituted or unsubstituted $C_2$-$C_{30}$ alkenylene group; a substituted or unsubstituted $C_3$-$C_{30}$ cycloalkenylene group; a substituted or unsubstituted $C_3$-$C_{30}$ heterocycloalkenylene group; a substituted or unsubstituted $C_6$-$C_{30}$ arylene group; or a substituted or unsubstituted $C_1$-$C_{30}$ heteroarylene group.

In an embodiment, $L_{14}$ in Formula 1 may be selected from a $C_1$-$C_{20}$ alkylene group, a $C_3$-$C_{20}$ cycloalkylene group, a $C_3$-$C_{20}$ heterocycloalkylene group, a $C_2$-$C_{20}$ alkenylene group, a $C_3$-$C_{20}$ cycloalkenylene group, a $C_3$-$C_{20}$ heterocycloalkenylene group, a $C_6$-$C_{20}$ arylene group, and a $C_1$-$C_{20}$ heteroarylene group, each unsubstituted or substituted with deuterium, a halogen, a cyano group, a hydroxy group, an amino group, a carboxylic acid group, a thiol group, an ester moiety, a sulfonate ester moiety, a carbonate moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_3$-$C_{20}$ cycloalkyl group, a $C_3$-$C_{20}$ cycloalkoxy group, a $C_6$-$C_{20}$ aryl group, or any combination thereof.

In an embodiment, $L_{14}$ in Formula 1 may be selected from a $C_1$-$C_{20}$ alkylene group, a $C_3$-$C_{20}$ cycloalkylene group, a $C_3$-$C_{20}$ heterocycloalkylene group, a phenylene group, and a naphthylene group, each unsubstituted or substituted with deuterium, a halogen, a $C_1$-$C_{20}$ alkyl group, a $C_1$-$C_{20}$ halogenated alkyl group, a $C_1$-$C_{20}$ alkoxy group, a phenyl group, a naphthyl group, or any combination thereof.

In Formula 1, a11 to a13 represent the number $L_{11}$ to $L_{13}$, respectively.

In an embodiment, a11 to a13 in Formula 1 may each independently be an integer from 1 to 3.

In an embodiment, a11 to a13 in Formula 1 may each be 1.

In an embodiment, $A_{11}$ in Formula 1 may be a benzene group, a naphthalene group, a phenanthrene group, an anthracene group, a chrysene group, a pyrene group, a triphenylene group, a fluorene group, a pyrrole group, a pyridine group, a pyrimidine group, a pyrazine group, a triazine group, a quinoline group, an isoquinoline group, a carbazole group, a furan group, a benzofuran group, a dibenzofuran group, a thiophene group, a benzothiophene group, or a dibenzothiophene group.

In an embodiment, $A_{11}$ in Formula 1 may be a benzene group, a naphthalene group, a phenanthrene group, an anthracene group, a chrysene group, a pyrene group, a triphenylene group, or a fluorene group.

In an embodiment, $A_{11}$ in Formula 1 may be a benzene group or a naphthalene group.

In an embodiment, $R_{11}$ and $R_{12}$ in Formula 1 may each independently be selected from: hydrogen; deuterium; a halogen; a cyano group; a hydroxy group; an amino group; a carboxylic acid group; a thiol group; and a $C_1$-$C_{20}$ alkyl group, a $C_3$-$C_{20}$ cycloalkyl group, and a $C_6$-$C_{20}$ aryl group, each unsubstituted or substituted with deuterium, a halogen, a cyano group, a hydroxy group, an amino group, a carboxylic acid group, a thiol group, an ester moiety, a sulfonate ester moiety, a carbonate moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_3$-$C_{20}$ cycloalkyl group, a $C_3$-$C_{20}$ cycloalkoxy group, a $C_6$-$C_{20}$ aryl group, or any combination thereof.

In an embodiment, $R_{11}$ in Formula 1 may be hydrogen, deuterium, a halogen, $CH_3$, $CH_2F$, $CHF_2$, $CF_3$, $CH_2CH_3$, $CHFCH_3$, $CHFCH_2F$, $CHFCHF_2$, $CHFCF_3$, $CF_2CH_3$, $CF_2CH_2F$, $CF_2CHF_2$ or $CF_2CF_3$.

In an embodiment, $R_{12}$ in Formula 1 may be: hydrogen; deuterium; a halogen; a cyano group; a hydroxy group; an amino group; a carboxylic acid group; a thiol group; a $C_1$-$C_{20}$ alkyl group; a $C_1$-$C_{20}$ halogenated alkyl group; a $C_3$-$C_{20}$ cycloalkyl group; or a $C_6$-$C_{20}$ aryl group.

In an embodiment, $X_{11}$ in Formula 1 may be OH.

In an embodiment, the first repeating unit may be represented by Formula 1-1:

Formula 1-1

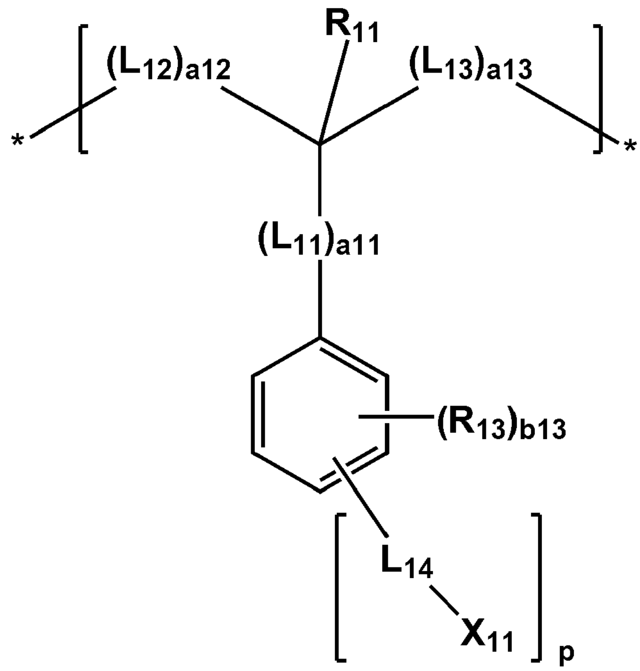

wherein, in Formula 1-1,

$L_{11}$ to $L_{14}$, a11 to a13, $X_{11}$, $R_{11}$, and p may each be defined as in Formula 1,
$R_{13}$ may be hydrogen, deuterium, a halogen, a cyano group, a hydroxy group, an amino group, a carboxylic acid group, a thiol group, an ester moiety, a sulfonate ester moiety, a carbonate moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_3$-$C_{20}$ cycloalkyl group, a $C_3$-$C_{20}$ cycloalkoxy group, or a $C_6$-$C_{20}$ aryl group,
b13 may be an integer from 1 to 5, and
* indicates a binding site to a neighboring atom.

In an embodiment, the first repeating unit may be selected from Group I:

Group I

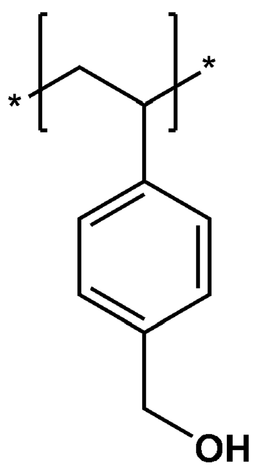

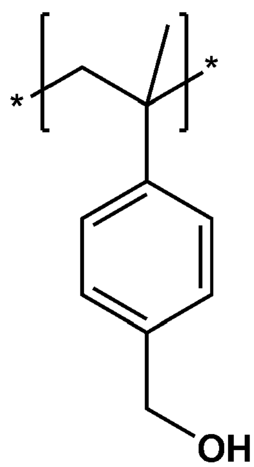

.

In one or more embodiments, the polymer may further include at least one of a second repeating unit represented by Formula 2 and a third repeating unit represented by Formula 3:

Formula 2

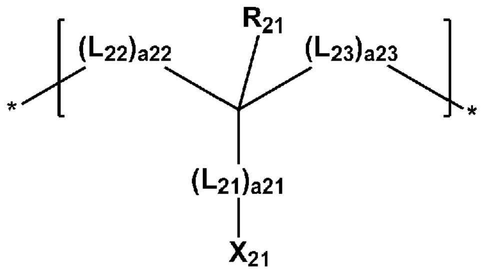

Formula 3

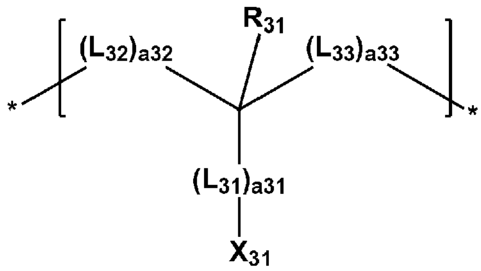

wherein, in Formulae 2 and 3,

$L_{21}$ to $L_{23}$ and $L_{31}$ to $L_{33}$ may each independently be: a single bond; O; C(=O); C(=O)O; OC(=O); C(=O)NH; NHC(=O); or a linear, branched, or cyclic $C_1$-$C_{30}$ divalent hydrocarbon group that optionally includes a heteroatom,
a21 to a23 and a31 to a33 may each independently be an integer from 1 to 4,
$R_{21}$ and $R_{31}$ may each independently be: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{30}$ monovalent hydrocarbon group that optionally includes a heteroatom,
$X_{21}$ may be an acid labile group,
$X_{31}$ may be a non-acid labile group, and
* indicates a binding site to a neighboring atom.

In an embodiment, $L_{21}$ to $L_{23}$ and $L_{31}$ to $L_{33}$ in Formulae 2 and 3 may each independently be defined as in $L_{11}$.
In an embodiment, a21 to a23 and a31 to a33 in Formulae 2 and 3 may each independently be defined as in a11.
In an embodiment, $R_{21}$ and $R_{31}$ in Formulae 2 and 3 may each independently be defined as in $R_{11}$.
In an embodiment, the polymer may include the second repeating unit represented by Formula 2 and $X_{21}$ in Formula 2 may be represented by Formula 4-1 or 4-2:

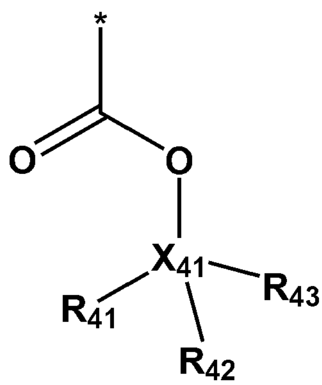

**4-1**

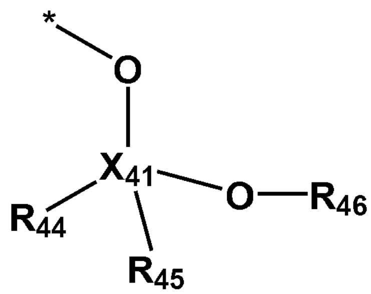

**4-2**

wherein, in Formulae 4-1 and 4-2,

$X_{41}$ may be a carbon atom or a silicon atom,
$R_{41}$ to $R_{45}$ may each independently be: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{30}$ monovalent hydrocarbon group that optionally includes a heteroatom,
$R_{46}$ may be a linear, branched, or cyclic $C_1$-$C_{30}$ monovalent hydrocarbon group that optionally includes a heteroatom,
an adjacent two of $R_{41}$ to $R_{46}$ may optionally be bonded to each other to form a ring, and
* indicates a binding site to a neighboring atom.

In an embodiment, $R_{41}$ to $R_{43}$ in Formulae 4-1 and 4-2 may not be simultaneously selected from hydrogen,

deuterium, a halogen, a cyano group, and an amino group.

In an embodiment, the polymer may include the second repeating unit represented by Formula 2 and $X_{21}$ in Formula 2 may be selected from groups represented by Formulae 5-1 to 5-11:

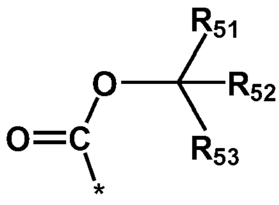
5-1

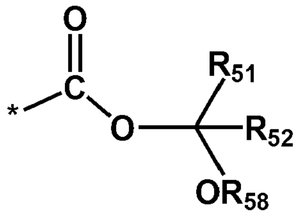
5-2

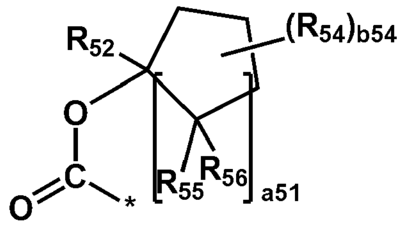
5-3

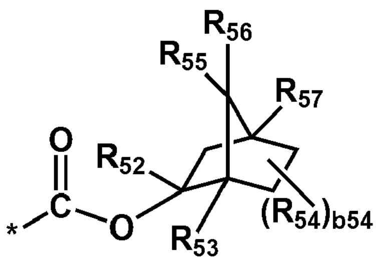
5-4

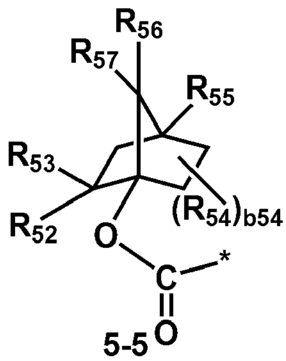
5-5

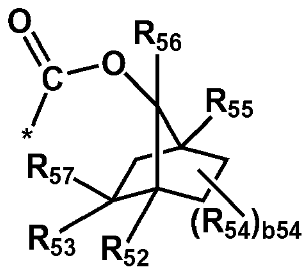
5-6

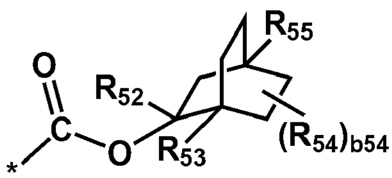
5-7

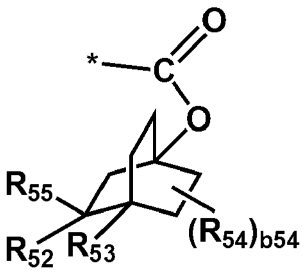
5-8

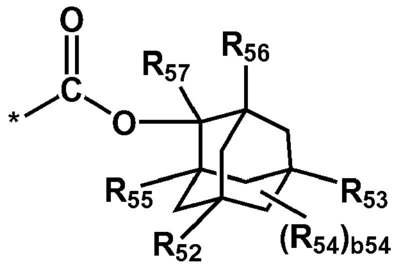
5-9

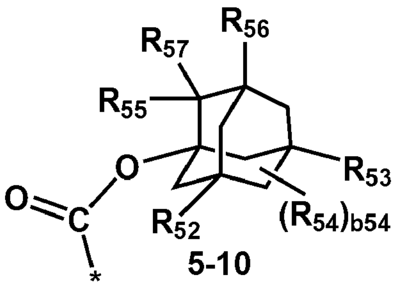
5-10

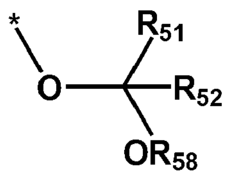
5-11

wherein, in Formulae 5-1 to 5-11,

a51 may be an integer from 0 to 6,

$R_{51}$ and $R_{58}$ may each independently be a linear, branched, or cyclic $C_1$-$C_{20}$ monovalent hydrocarbon group which may optionally include a heteroatom,

$R_{52}$ to $R_{57}$ may each independently be: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{20}$ monovalent hydrocarbon group that optionally includes a heteroatom, an adjacent two of $R_{51}$ to $R_{58}$ may optionally be bonded

to each other to form a ring, b54 may be an integer from 1 to 10, and
* indicates a binding site to a neighboring atom.

When a51 in Formula 5-3 is 0, $(CR_{55}R_{56})_{a51}$ may be a single bond.
In an embodiment, $X_{21}$ in Formula 2 may be selected from groups represented by Formulae 5-1 and 5-3.
In an embodiment, the polymer may include the second repeating unit represented by Formula 2 and the second repeating unit may be represented by one of or two or more selected from Group II:

Group II

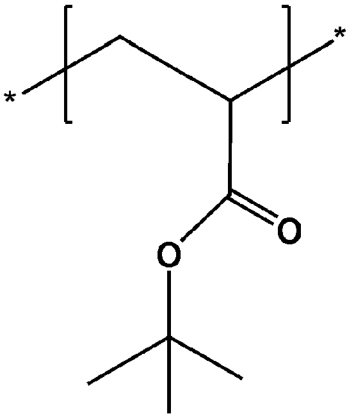
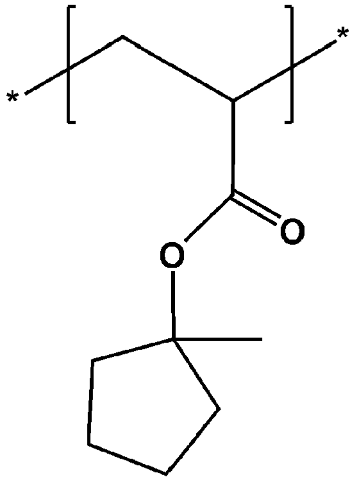
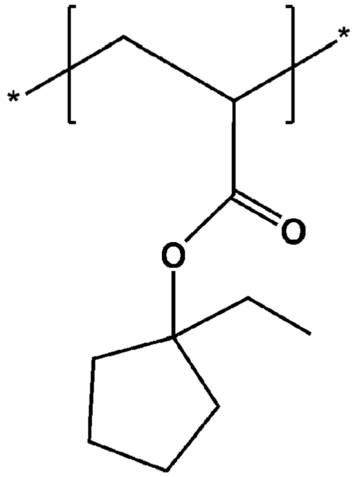
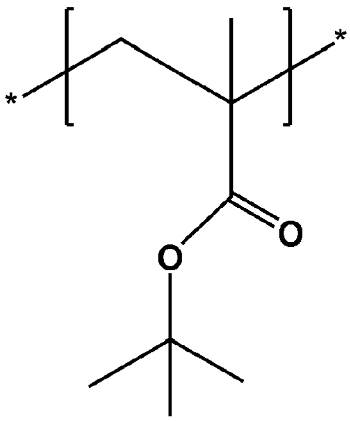
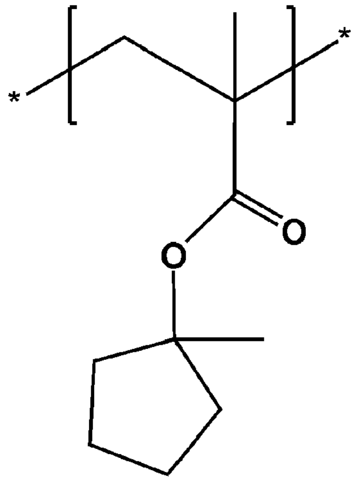
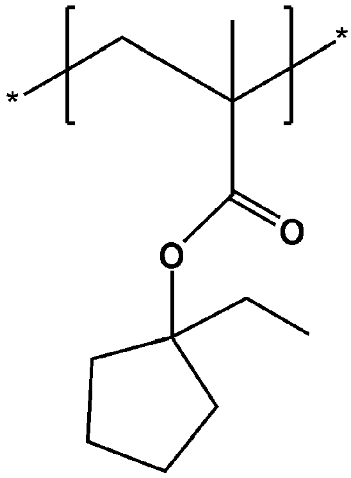

.

In an embodiment, the polymer may include the third repeating unit represented by Formula 3 and $X_{31}$ in Formula 3 may be: hydrogen; a halogen; a cyano group; a hydroxy group; a carboxylic acid group; a thiol group; an amino group; or a linear, branched, or cyclic $C_1$-$C_{30}$ monovalent hydrocarbon group that optionally includes one or more polar moieties selected from halogen, a cyano group, a hydroxy group, a thiol group, a carboxylic acid group, O, C=O, C(=O)O, OC(=O), S(=O)O, OS(=O), a lactone moiety, a sultone moiety, and a carboxylic anhydride moiety.
In an embodiment, $X_{31}$ in Formula 3 may be: hydrogen; a hydroxy group; or a linear, branched, or cyclic $C_1$-$C_{30}$ monovalent hydrocarbon group that includes one or more polar moieties selected from a hydroxy group, O, C=O, C(=O)O, OC(=O), a lactone moiety, and a carboxylic anhydride moiety.
In an embodiment, the polymer may include the third repeating unit represented by Formula 3 and $X_{31}$ in Formula 3 may be: hydrogen; a hydroxy group; or a group represented by one of Formulae 6-1 to 6-10:

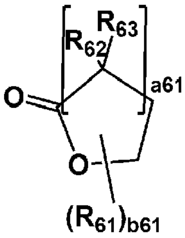 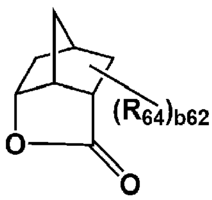 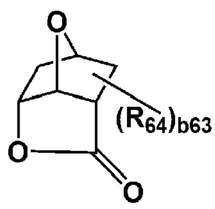 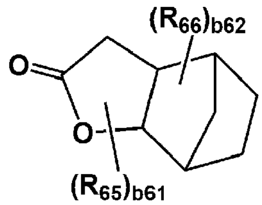 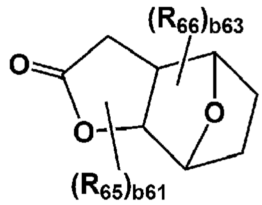

6-1 6-2 6-3 6-4 6-5

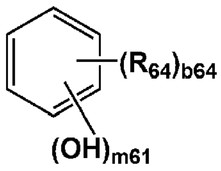 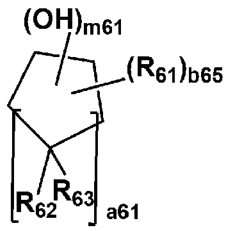 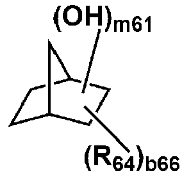 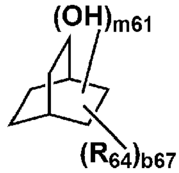 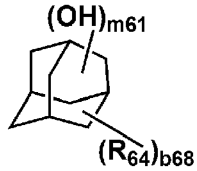

6-6 6-7 6-8 6-9 6-10

wherein, in Formulae 6-1 to 6-10,

a61 may be 1 or 2,
$R_{61}$ to $R_{66}$ may each independently be: a binding site to a neighboring atom; hydrogen; a hydroxy group; a carboxylic acid group; an ester moiety; a carbonate moiety; a lactone moiety; a carboxylic anhydride moiety; or a linear, branched, or cyclic $C_1$-$C_{20}$ monovalent hydrocarbon group,
one of $R_{61}$ to $R_{63}$, one of $R_{64}$, and one of $R_{65}$ and $R_{66}$ may each be a binding site to a neighboring atom,
b61 may be an integer from 1 to 4,
b62 may be an integer from 1 to 10,
b63 may be an integer from 1 to 8,
b64 may be an integer from 1 to 5,
b65 may be an integer from 1 to 7,
b66 may be an integer from 1 to 11,
b67 may be an integer from 1 to 13,
b68 may be an integer from 1 to 15, and
m61 may be an integer from 1 to 4.

In an embodiment, the polymer may include the third repeating unit represented by Formula 3 and $X_{31}$ in Formula 3 may be selected from a hydroxy group and a group represented by Formula 6-6.

In an embodiment, the polymer may include the third repeating unit represented by Formula 3 and the third repeating unit may be represented by one of or two or more selected from Group III:

Group III

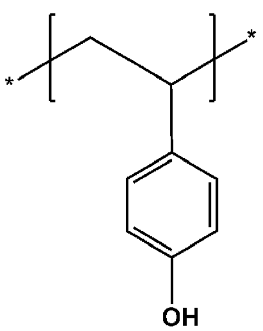 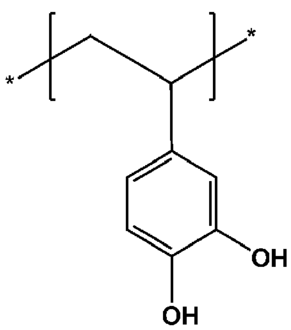 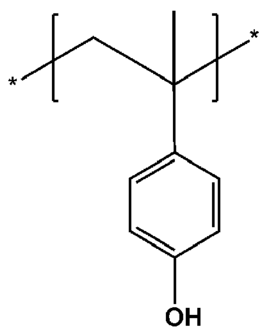 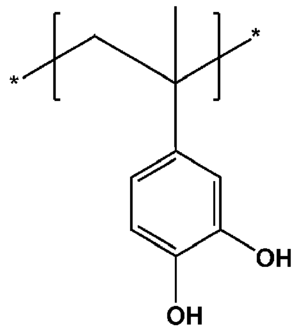

In an embodiment, the polymer may include the first repeating unit in an amount in a range of about 1 mol% to about 100 mol%, about 5 mol% to about 100 mol%, and about 10 mol% to about 100 mol%.

In one or more embodiments, the polymer may consist of the first repeating unit.

In one or more embodiments, the polymer may include the second repeating unit in an amount in a range of about 0 mol% to about 99 mol%, about 1 mol% to about 99 mol%, and about 10 mol% to about 90 mol%.

In one or more embodiments, the polymer may include the third repeating unit in an amount in a range of about 0 mol% to about 99 mol%, about 1 mol% to about 99 mol%, and about 10 mol% to about 90 mol%.

In one or more embodiments, the polymer may consist of the first repeating unit and the second repeating unit. In one or more embodiments, the polymer may include the first repeating unit in an amount in a range of about 1 mol% to about 99 mol% or about 10 mol% to about 90 mol%, and the second repeating unit in an amount in a range of about 1 mol% to about 99 mol% or about 10 mol% to about 90 mol%.

In one or more embodiments, the polymer may consist of the first repeating unit and the third repeating unit. In one or more embodiments, the polymer may include the first repeating unit in an amount in a range of about 1 mol% to about 99 mol% or about 10 mol% to about 90 mol%, and the third repeating unit in an amount in a range of about 1 mol% to about 99 mol% or about 10 mol% to about 90 mol%.

In one or more embodiments, the polymer may consist of the first repeating unit, the second repeating unit, and the third repeating unit. In one or more embodiments, the polymer may include the first repeating unit in an amount in a range of about 1 mol% to about 98 mol% or about 5 mol% to about 90 mol%, the second repeating unit in an amount in a range of about 1 mol% to about 98 mol% or about 5 mol% to about 90 mol%, and the third repeating unit in an amount in a range of about 1 mol% to about 98 mol% or about 5 mol% to about 90 mol%.

The polymer may have a weight average molecular weight (Mw) in a range of about 1,000 to 500,000, for example, about 3,000 to about 100,000 or about 5,000 to about 50,000, wherein the weight average molecular weight is measured by gel permeation chromatography using a tetrahydrofuran solvent and polystyrene as a standard material.

The polymer may have polydispersity index (PDI: Mw/Mn) in a range of about 1.0 to about 3.0, for example, about 1.0 to about 2.5. When the PDI of the polymer is satisfied within the ranges above, there is a less chance of remaining foreign substances on a pattern, or deterioration of a pattern profile may be minimized. Accordingly, a resist composition including the polymer may be more suitable for forming fine patterns.

The structure (composition) of the polymer may be confirmed by performing FT-IR analysis, NMR analysis, X-ray fluorescence (XRF) analysis, mass spectrometry, UV analysis, single crystal X-ray structure analysis, powder X-ray diffraction (PXRD) analysis, liquid chromatography (LC) analysis, size exclusion chromatography (SEC) analysis, thermal analysis, and the like. A detailed confirmation method is as described in Examples below.

Typically, since EUV (13.5 nm) has a lower number of photons compared to ArF (193 nm) immersion light sources at the same exposure dose, the lower the exposure dose is, noise increases significantly at the boundary area between the area exposed by the EUV light source and the unexposed area that is not exposed. In the case of a lithography process using an EUV light source, in order to compensate for this, a larger amount of a photoacid generator may be used compared to a lithography process using another light source having the same amount of light. However, when the resist composition includes a high content of a photoacid generator, the glass transition temperature (Tg) of the base resin may change and thermal stability thereof may deteriorate. In addition, the resolution of resist patterns formed due to a photoacid generator remaining during a lithography process using an EUV light source, may deteriorate.

The polymer including the first repeating unit represented by Formula 1 may be cross-linked under an acid catalyst, and specifically, may be cross-linked through a condensation reaction by heat. In other words, the polymer including the first repeating unit represented by Formula 1 may be cross-linked by an etherification reaction when an acid formed from the photoacid generator by high-energy rays acts as a catalyst, for example, when $X_{11}$ is OH. Therefore, the physical properties of the polymer may be changed even with a relatively small amount of a photoacid generator, and thus the resolution of resist patterns obtained therefrom may be improved.

In addition, when the polymer including the first repeating unit represented by Formula 1 is cross-linked, the solubility thereof in a developer may be reduced compared to solubility of a polymer without cross-linking, and the resolution of resist patterns obtained therefrom may be improved.

Furthermore, since the polymer including the first repeating unit represented by Formula 1 is cross-linked, the elastic modulus of a resist film thus formed may be improved, so that defects caused by pattern collapse during a pattern preparation process may be reduced.

Furthermore, since the polymer including the first repeating unit represented by Formula 1 is cross-linked, the etch resistance may be improved, the etching speed may be reduced, and the thickness of a resist film remaining after development may be relatively thick, and thus the remnant ratio of a resist film may be improved.

**[Resist composition]**

Another aspect provides a resist composition including the polymer, a photoacid generator, and an organic solvent. The resist composition may have, for example, improved developability and/or improved resolution.

The solubility of the resist composition in a developer is changed by exposure to high-energy rays. The resist composition may be a positive resist composition corresponding to a case where an exposed portion of the resist film is

dissolved and removed to form a positive resist pattern, or a negative resist composition corresponding to a case where an unexposed portion of the resist film is dissolved and removed to form a negative resist pattern. Specifically, the resist composition may be a negative resist composition.

In addition, the resist composition according to an embodiment may be used for an alkali developing process using an alkali developer for a developing process in forming a resist pattern, or may be used for a solvent developing process using a developer containing an organic solvent for the developing process (hereinafter referred to as an organic developer).

As the polymer including the repeating unit represented by Formula 1 for use in the resist composition, one type of the polymer or a combination of two or more different types of the polymer may be used.

The polymer may be included in an amount of about 0.1 parts by weight to about 10 parts by weight based on 100 parts by weight of the resist composition. Specifically, the polymer may be included in an amount of about 0.5 parts by weight to about 5 parts by weight based on 100 parts by weight of the resist composition. When the amount of the polymer is satisfied within the ranges above, any performance loss, such as degradation in sensitivity and/or reduction in formation of foreign particles due to lack of solubility, may be reduced.

Regarding the polymer as described above, the photoacid generator, the organic solvent, and optional components such as a quencher contained as necessary will be described below.

<Photoacid generator>

The photoacid generator may be any compound capable of generating an acid when exposed to high-energy rays such as UV rays, DUV rays, an EB, EUV rays, X-rays, $\alpha$-rays, and $\gamma$-rays.

The photoacid generator may include a sulfonium salt, an iodonium salt, or a combination thereof.

In an embodiment, the photoacid generator may be represented by Formula 7:

Formula 7 $B_{71}^{+}\ A_{71}^{-}$

wherein, in Formula 7,

$B_{71}^{+}$ may be represented by Formula 7A, and $A_{71}^{-}$ may be represented by one of Formulae 7B to 7D, and $B_{71}^{+}$ and $A_{71}^{-}$ may optionally be linked via a carbon-carbon covalent bond:

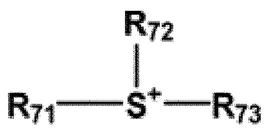

7A

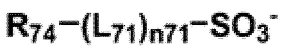

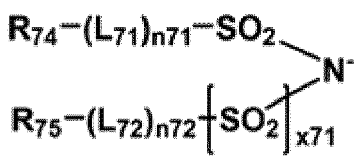

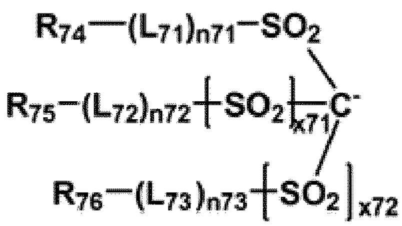

7B 7C 7D

In Formulae 7A to 7D,

$L_{71}$ to $L_{73}$ may each independently be a single bond or CRR',

R and R' may each independently be hydrogen, deuterium, a halogen, a cyano group, a hydroxy group, a $C_1$-$C_{30}$ alkyl

group, a $C_1$-$C_{30}$ halogenated alkyl group, a $C_1$-$C_{30}$ alkoxy group, a $C_3$-$C_{30}$ cycloalkyl group, or a $C_3$-$C_{30}$ cycloalkoxy group,

n71 to n73 may each independently be 1, 2, or 3,

x71 and x72 may each independently be 0 or 1,

$R_{71}$ to $R_{73}$ may each independently be a linear, branched, or cyclic $C_1$-$C_{30}$ monovalent hydrocarbon group that optionally includes a heteroatom,

an adjacent two of $R_{71}$ to $R_{73}$ may optionally be bonded to each other to form a condensed ring, and

$R_{74}$ to $R_{76}$ may each independently be: hydrogen; a halogen; or a linear, branched, or cyclic $C_1$-$C_{30}$ monovalent hydrocarbon group that optionally includes a heteroatom.

For example, in Formula 7, $B_{71}^+$ may be represented by Formula 7A, and $A_{71}^-$ may be represented by Formula 7B. Specifically, $R_{71}$ to $R_{73}$ in Formula 7 may each be a phenyl group.

The photoacid generator may be included in an amount in a range of about 0.01 parts by weight to about 40 parts by weight, about 0.1 parts by weight to about 40 parts by weight, or about 0.1 parts by weight to about 20 parts by weight, based on 100 parts by weight of the polymer. When the amount of the photoacid generator is satisfied within the ranges above, proper resolution may be achieved, and problems related to foreign particles after development or during stripping may be reduced.

One type of the photoacid generator may be used, or a combination of two or more different types of the photoacid generator may be used.

<Organic solvent>

The organic solvent included in the resist composition may not be particularly limited as long as it is capable of dissolving or dispersing a polymer, a photoacid generator, and optional components such as a quencher contained as necessary.

One type of the organic solvent may be used, or a combination of two or more different types of the organic solvent may be used. Also, a mixed solvent in which water and an organic solvent are mixed may be used.

Examples of the organic solvent may include an alcohol-based solvent, an ether-based solvent, a ketone-based solvent, an amide-based solvent, an ester-based solvent, a sulfoxide-based solvent, a hydrocarbon-based solvent, and the like.

Examples of the alcohol-based solvent may include: a monoalcohol-based solvent, such as methanol, ethanol, n-propanol, isopropanol, 1-methoxy-2-propanol, 1-ethoxy-2-propanol, n-butanol, isobutanol, sec-butanol, tert-butanol, n-pentanol, isopentanol, 2-methylbutanol, sec-pentanol, tert-pentanol, 3-methoxybutanol, 3-methyl-3-methoxybutanol, n-hexanol, 2 -methylpentanol, sec-hexanol, 2-ethylbutanol, 4-methyl-2-pentanol (MIBC), sec-heptanol, 3-heptanol, n-octanol, 2-ethylhexanol, sec-octanol, n-nonylalcohol, 2,6- dimethyl-4-heptanol, n-decanol, sec-undecyl alcohol, trimethylnonyl alcohol, sec-tetradecyl alcohol, sec-heptadecyl alcohol, furfuryl alcohol, phenol, cyclohexanol, methylcyclohexane alcohol, 3,3,5-trimethylcyclohexanol, benzyl alcohol, diacetone alcohol, and the like; a polyhydric alcohol solvent, such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, and tripropylene glycol; and polyhydric alcohol-containing ether solvents such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, diethylene glycol dimethyl ether, propylene glycol monomethyl ether, propylene glycol dimethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, and the like.

Examples of the ether-based solvent may include: a dialkyl ether-based solvent, such as diethyl ether, dipropyl ether, dibutyl ether, and the like; a cyclic ether-based solvent, such as tetrahydrofuran, tetrahydropyran, and the like; an aromatic ring-containing ether-based solvent, such as diphenyl ether, anisole, and the like; and the like.

Examples of the ketone-based solvent may include: a chain ketone-based solvent, such as acetone, methylethyl ketone, methyl-n-propyl ketone, methyl-n-butyl ketone, methyl-n-pentyl ketone, diethyl ketone, methyl isobutyl ketone, 2-heptanone, ethyl-n-butyl ketone, methyl-n-hexyl ketone, diisobutyl ketone, trimethylnonanone, and the like; a cyclic ketone solvent, such as cyclopentanone, cyclohexanone, cycloheptanone, cyclooctanone, methylcyclohexanone, and the like; 2,4-pentanedione; acetonylacetone; acetphenone; and the like.

Examples of the amide-based solvent may include: a cyclic amide-based solvent, such as N,N'-dimethylimidazolidinone, N-methyl-2-pyrrolidone, and the like; a chain amide-based solvent, such as N-methylformamide, N,N-dimethylformamide, N,N-diethylformamide, acetamide, N-methylacetamide, N,N-dimethylacetamide, N-methylpropionamide, and the like; and the like.

Examples of ester solvent may include: an acetate ester solvent, such as methyl acetate, ethyl acetate, n-propyl acetate, isopropyl acetate, n-butyl acetate, isobutyl acetate, sec-butyl acetate, T-butyl acetate, n-pentyl acetate, isopentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, and the like; a polyhydric alcohol-containing ether carboxylate solvent, such as ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, and the like; a lactone solvent, such as $\gamma$-butyrolactone and $\delta$-valerolactone; carbonate solvents such as dimethyl carbonate, diethyl carbonate, ethylene carbonate, and propylene carbonate; lactate ester solvents such as methyl lactate, ethyl lactate, n-butyl lactate, n-amyl lactate, and the like; glycoldiacetate; methoxytriglycol acetate; ethyl propionate; n-butyl propionate; isoamyl propionate; diethyloxalate; di-n-butyloxalate; methyl acetoacetate; ethyl acetoacetate; diethyl malonate; dimethyl phthalate; diethyl phthalate; and the like.

Examples of the sulfoxide-based solvent may include dimethyl sulfoxide, diethyl sulfoxide, and the like.

Examples of the hydrocarbon-based solvent may include: an aliphatic hydrocarbon-based solvent, such as n-pentane, isopentane, n-hexane, isohexane, n-heptane, isoheptane, 2,2,4-trimethyl pentane, n-octane, isooctane, cyclohexane, methylcyclohexane, and the like; and an aromatic hydrocarbon-based solvent, such as benzene, toluene, xylene, mesitylene, ethyl benzene, trimethyl benzene, methylethyl benzene, n-propyl benzene, isopropyl benzene, diethyl benzene, isobutyl benzene, triethyl benzene, diisopropyl benzene, n-amylnaphthalene, and the like.

In an embodiment, the organic solvent may be selected from an alcohol-based solvent, an amide-based solvent, an ester-based solvent, a sulfoxide-based solvent, and any combination thereof. In one or more embodiments, the organic solvent may be selected from propylene glycol monomethyl ether, propylene glycol monoethyl ether, propylene glycol monomethyl ether acetate, N-methyl-2-pyrrolidone, N,N-dimethylacetamide, ethyl lactate, dimethyl sulfoxide, and any combination thereof.

In an embodiment, when an acid labile group in the form of acetal is used, the organic solvent may further include high-boiling alcohol, such as diethylene glycol, propylene glycol, glycerol, 1,4-butanediol, or 1,3-butanediol, in order to accelerate the deprotection reaction of acetal.

The organic solvent may be used in an amount in a range of about 200 parts by weight to about 20,000 parts by weight, for example, about 2,000 to about 10,000 parts by weight, based on 100 parts by weight of the polymer.

<Quencher>

The resist composition may further include a quencher.

The quencher may be a salt that generates an acid with weaker acidity than the acid generated from the photoacid generator.

The quencher may include an ammonium salt, a sulfonium salt, an iodonium salt, and a combination thereof.

In an embodiment, the quencher may be represented by Formula 8:

Formula 8 $B_{81}^{+}\ A_{81}^{-}$

wherein, in Formula 8,

$B_{81}^{+}$ may be represented by one of Formulae 8A to 8C, and $A_{81}^{-}$ may be represented by one of Formulae 8D to 8F, and $B_{81}^{+}$ and $A_{81}^{-}$ may optionally be linked to each other via a carbon-carbon covalent bond:

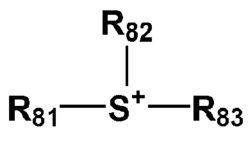

8A

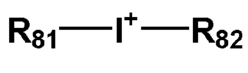

8B

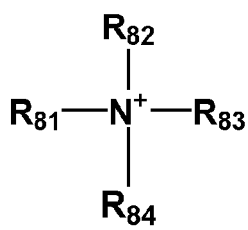

8C

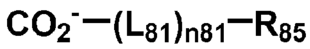

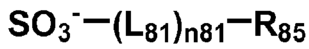

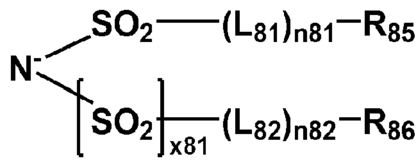

8D 8E 8F

wherein, in Formulae 8A to 8F,

$L_{81}$ and $L_{82}$ may each independently be a single bond or CRR',

R and R' may each independently be hydrogen, deuterium, a halogen, a cyano group, a hydroxy group, a $C_1$-$C_{30}$ alkyl group, a $C_1$-$C_{30}$ halogenated alkyl group, a $C_1$-$C_{30}$ alkoxy group, a $C_3$-$C_{30}$ cycloalkyl group, or a $C_3$-$C_{30}$ cycloalkoxy group,

n81 and n82 may each independently be 1, 2, or 3,

x81 may be 0 or 1,

$R_{81}$ to $R_{84}$ may each independently be a linear, branched, or cyclic $C_1$-$C_{30}$ monovalent hydrocarbon group that optionally includes a heteroatom,

an adjacent two of $R_{81}$ to $R_{84}$ may optionally be bonded to each other to form a condensed ring, and

$R_{85}$ and $R_{86}$ may each independently be: hydrogen; a halogen; or a linear, branched, or cyclic $C_1$-$C_{30}$ monovalent hydrocarbon group that optionally includes a heteroatom.

The quencher may be included in an amount in a range of about 0 part by weight to about 10 parts by weight, 0.05 parts by weight to about 5 parts by weight, or about 0.1 parts by weight to about 3 parts by weight, based on 100 parts by weight of the polymer. When the amount of the photoacid generator is satisfied within the ranges above, proper resolution may be achieved, and problems related to foreign particles after development or during stripping may be reduced.

One type of the quencher may be used, or two or more different types of the quencher may be used in combination.

<Base resin>

The resist composition may further include a base resin.

The base resin may include a repeating unit represented by Formula 2 and including an acid labile group:

Formula 2

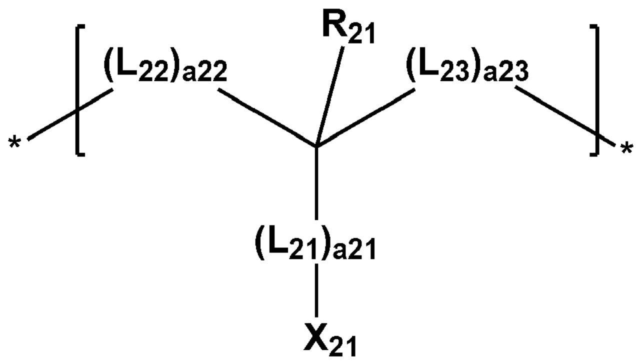

wherein, in Formula 2,

$L_{21}$ to $L_{23}$ may each independently be: a single bond; O; C(=O); C(=O)O; OC(=O); C(=O)NH; NHC(=O); or a linear, branched, or cyclic $C_1$-$C_{30}$ divalent hydrocarbon group that optionally includes a heteroatom,

a21 to a23 may each independently be an integer from 1 to 4,

$R_{21}$ may be: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{30}$ monovalent hydrocarbon group that optionally includes a heteroatom,

$X_{21}$ may be an acid labile group, and

* indicates a binding site to a neighboring atom.

A description of Formula 2 may be defined as described above.

The base resin including the repeating unit represented by Formula 2 may be decomposed under the action of an acid to generate a carboxyl group, thereby being converted to have alkali-solubility.

In addition to the repeating unit represented by Formula 2, the base resin may further include a repeating unit represented by Formula 3:

Formula 3

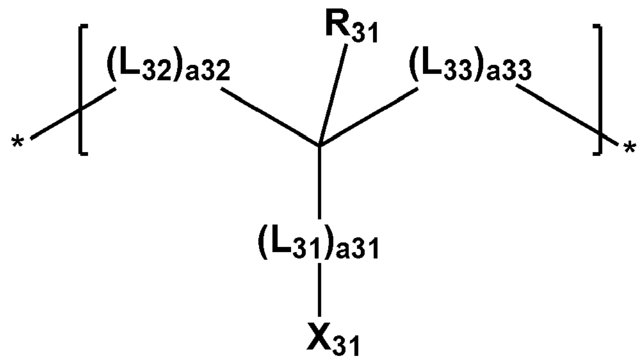

wherein, in Formula 3,

$L_{31}$ to $L_{33}$ may each independently be: a single bond; O; C(=O); C(=O)O; OC(=O); C(=O)NH; NHC(=O); or a linear, branched, or cyclic $C_1$-$C_{30}$ divalent hydrocarbon group that optionally includes a heteroatom,
a31 to a33 may each independently be an integer from 1 to 4,
$R_{31}$ may be: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{30}$ monovalent hydrocarbon group that optionally includes a heteroatom,
$X_{31}$ may be a non-acid labile group, and
* indicates a binding site to a neighboring atom.

A description of Formula 3 may be defined as described above.

For example, in ArF lithography processes, $X_{31}$ may include a lactone ring as a polar moiety, and in KrF, EB, and EUV lithography processes, $X_{31}$ may be phenol.

In an embodiment, the base resin may further include a moiety including an anion and/or a cation. For example, the base resin may further include a moiety in which a photoacid generator and/or a quencher are induced to bind to the side chain.

The base resin may have a weight average molecular weight (Mw) in a range of about 1,000 to 500,000, for example, about 3,000 to about 100,000, wherein the weight average molecular weight (Mw) is measured by gel permeation chromatography using a tetrahydrofuran solvent and polystyrene as a standard material.

The base resin may have PDI (Mw/Mn) in a range of about 1.0 to about 3.0, for example, about 1.0 to about 2.0. When the PDI of the base resin is satisfied within the ranges above, there is a less chance of remaining foreign substances on a pattern, or deterioration of a pattern profile may be minimized. Accordingly, the resist composition including the polymer may be more suitable for forming fine patterns.

The base resin may be prepared by any suitable method, for example, a method in which unsaturated bond-containing monomer(s) is dissolved in an organic solvent and the thermally polymerized in the presence of a radical initiator.

In the base resin, a mole fraction (mol%) of each repeating unit derived from each monomer is as follows, but is not limited thereto:

i) the repeating unit represented by Formula 2 is included in an amount in a range of about 1 mol% to about 60 mol%, for example, about 5 mol% to about 50 mol%, and for example, about 10 mol% to about 50 mol%; and
ii) the repeating unit represented by Formula 3 is included in an amount in a range of about 40 mol% to about 99 mol%, for example, about 50 mol% to about 95 mol%, and for example, about 50 mol% to about 90 mol%.

The base resin may be a homopolymer, or may include a mixture of two or more types of polymers having a different composition, a different weight average molecular weight (Mw), and/or a different PDI (Mw/Mn).

<Optional components>

The resist composition may further include a surfactant, a cross-linking agent, a leveling agent, a colorant, or any combination thereof, if needed.

The resist composition may further include a surfactant to improve a coating property and developability. Examples of the surfactant may include: a non-ionic surfactant, such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, polyethylene glycol distearate, and the like; and the like. For use as the surfactant, a commercially available product may be used, or a synthetic product may be used. Examples of the commercially available product may include KP341 (manufactured by Shin-Etsu Chemical Co., Ltd.), POLYFLOW No.75 and POLYFLOW No.95 (manufactured by Kyoeisha Chemical Co., Ltd.), FTOP EF301, FTOP EF303, and FTOP EF352 (manufactured by Mitsubishi Materials Electronic Chemicals Co., Ltd.), MEGAFACE F171 (registered trademark), MEGAFACE F173, R40, R41, and R43 (manufactured by DIC Corporation), Fluorad FC430 (registered trademark) and Fluorad FC431 (manufactured by 3M Company), AsahiGuard AG710 (product of AGC Corporation), Surflon S-382 (registered trademark), Surflon SC-101, Surflon SC-102, Surflon SC-103, Surflon SC-104, Surflon SC-105, and Surflon SC-106 (manufactured by AGC Seimi Chemical Co., Ltd.), and the like.

The surfactant may be included in an amount in a range of about 0 parts by weight to about 20 parts by weight based on 100 parts by weight of the polymer.

One type of the surfactant may be used, or a combination of two or more different types of the surfactant may be used.

A method of preparing the resist composition is not particularly limited, and for example, a method of mixing a polymer, a photoacid generator, and optional components added as necessary in an organic solvent may be used. The temperature or time at the mixing is not particularly limited. Filtration may be performed after the mixing as needed.

**[Pattern formation method]**

Hereinafter, a pattern formation method according to embodiments will be described in more detail with reference to FIGS. 1 and 2A to 2C. FIG. 1 is a flowchart representing a pattern formation method according to an embodiment, and FIGS. 2A to 2C are each a side cross-sectional view illustrating a pattern formation method according to an embodiment. Hereinafter, an example of a pattern formation method using a negative resist composition will be described, but embodiments of the disclosure are not limited thereto.

Referring to FIG. 1, the pattern formation method may include: forming a resist film by applying a resist composition (S101); exposing at least a portion of the resist film with high-energy rays (S102); and developing the exposed resist film by using a developer (S103). The steps above may be omitted as necessary, or may be performed in different orders.

First, a board 100 is prepared. The board 100 may be, for example, a semiconductor board, such as a silicon board or a germanium board, or may be formed of glass, quartz, ceramic, copper, and the like. In an embodiment, the board 100 may include a Group III-V compound, such as GaP, GaAs, GaSb, and the like.

A resist film 110 may be formed by applying a resist composition to a desired thickness on the board 100 by a coating method. If necessary, the method may include heating (prebaking (PB) or post-annealing baking (PAB) steps) to remove the organic solvent remaining in the resist film 110.

The coating method may include spin coating, dipping, roller coating, or other common coating methods. In an embodiment, spin coating may be used, and the thickness of the resist film 110 may be adjusted by controlling the viscosity, concentration, and/or spin speed of the resist composition. In an embodiment, the thickness of the photoresist film 110 may be in a range of about 10 nm to about 300 nm. In one or more embodiments, the thickness of the resist film 110 may be on a range of about 30 nm to about 200 nm.

The lower limit of a PB temperature may be 60 °C or higher, for example, 80 °C or higher. In addition, the upper limit of the PB temperature may be 150 °C or lower, for example, 140 °C or lower. The lower limit of a PB time may be 5 seconds or more, for example, 10 seconds or more. The upper limit of the PB time may be 600 seconds or less, for example, 300 seconds or less.

Before coating the resist composition on the board 100, an etch target film (not shown) may be further formed on the board 100. The etch target film may refer to a layer on which an image is transferred from a resist pattern and converted into a certain pattern. In an embodiment, the film to be etched may be formed to include, for example, an insulating material, such as silicon oxide, silicon nitride, or silicon oxynitride. In one or more embodiments, the film to be etched may be formed to include a conductive material, such as metal, metal nitride, metal silicide, or metal silicide nitride. In one or more

embodiments, the film to be etched may be formed to include a semiconductor material, such as polysilicon.

In an embodiment, an anti-reflection film may be further formed on the board 100 to maximize the efficiency of the resist. The anti-reflection film may be an organic-based anti-reflection layer or an inorganic-based anti-reflection layer.

In an embodiment, a protective film may be further provided on the resist film 110 in order to reduce the influence of alkaline impurities included in the process. Further, in the case of immersion exposure, for example, a protective film for immersion may be provided on the resist film 110 to avoid direct contact between the immersion medium and the resist film 110.

Next, at least a portion of the resist film 110 may be exposed to high-energy rays. For example, high-energy rays passing through a mask 120 may be irradiated to at least a portion of the resist film 110. As such, the resist film 110 may have an exposed portion 111 and a non-exposed portion 112.

The exposure may be carried out by irradiating high-energy rays through a mask having a predetermined pattern and by using liquid, such as water or the like, as a medium in some cases. Examples of the high-energy rays may include: electromagnetic waves, such as ultraviolet rays, far-ultraviolet rays, extreme ultraviolet rays (EUV rays, wavelength of 13.5 nm), X-rays, $\gamma$-rays, and the like; a charged particle beam, such as an electron beam (EB), $\alpha$-rays, and the like; and the like. The irradiation of such high-energy rays may be collectively referred to as "exposure".

For use as a light source of the exposure, various types of irradiation including: irradiating a laser beam in the ultraviolet region, such as a KrF excimer laser (wavelength of 248 nm), an ArF excimer laser (wavelength of 193 nm), and an $F_2$ excimer laser (wavelength of 157 nm); irradiating a harmonic laser beam in the far ultraviolet or vacuum ultraviolet region by a wavelength conversion method using a laser beam from a solid-state laser source (e.g., YAG or semiconductor laser); irradiating an EB rays or EUV rays; or the like may be used. Upon the exposure, the exposure may be performed through a mask corresponding to a desired pattern. However, when the light source of the exposure is an EB, the exposure may be performed by direct drawing without using a mask.

The integral dose of the high-energy rays may be 2,000 mJ/cm$^2$ or less, for example, 500 mJ/cm$^2$ or less, in the case of using EUV rays as the high-energy rays. In addition, in the case of using EB as the high-energy rays, the integral dose of the high-energy rays may be 5,000 $\mu$C/cm$^2$ or less, for example, 1,000 $\mu$C/cm$^2$ or less.

In addition, post-exposure baking (PEB) may be performed after the exposure. The lower limit of a PEB temperature may be 50 °C or higher, for example, 80 °C or higher. The upper limit of the PEB temperature may be 180 °C or less, for example, 130 °C or less. The lower limit of a PEB time may be 5 seconds or more, for example, 10 seconds or more. The upper limit of the PEB time may be 600 seconds or less, for example, 300 seconds or less.

Although not limited to a specific theory, a condensation reaction may proceed in the PEB, in which an acid formed by exposure acts as a catalyst, thereby forming cross-linking in the polymer.

Next, the exposed resist film 110 may be developed by using a developer. The exposed portion 111 may remain unwashed away by the developer, whereas the non-exposed portion 112 may be washed away by using the developer.

For use as the developer, an alkali developer, a developer containing an organic solvent (hereinafter also referred to as "organic developer"), and the like may be used. As a developing method, a dipping method, a puddle method, a spray method, a dynamic administration method, and the like may be used. The developing temperature may be, for example, 5 °C or more and 60 °C or less, and the developing time may be, for example, 5 seconds or more and 300 seconds or less.

The alkali developer may be, for example, an alkaline aqueous solution which dissolves at least one alkaline compound, such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethyl ammonium hydroxide (TMAH), pyrrole, piperidine, choline, 1,8-diazabicyclo[5.4.0]-7-undecene (DBU), 1,5-diazabicyclo[4.3.0]-5-nonene, and the like. The alkaline developer may further include a surfactant.

The lower limit of the amount of the alkaline compound in the alkaline developer may be 0.1 mass% or more, for example, 0.5 mass% or more, and for example, 1 mass% or more. In addition, the upper limit of the amount of the alkaline compound in the alkaline developer may be 20 mass% or less, for example, 10 mass% or less, and for example, 5 mass% or less.

As an organic solvent contained in the organic developer, for example, the same organic solvent as the organic solvent described in the <Organic solvent> of the [Resist composition] may be used.

The lower limit of the amount of the organic solvent in the organic developer may be 80 mass % or more, for example, 90 mass % or more, and for example, 95 mass % or more, and for example, 99 mass % or more.

The organic developer may include a surfactant, a trace amount of water, and/or acetic acid (AA). In addition, upon the development, the solvent may be substituted with a solvent of a different kind from the organic developer to stop the development.

The resist pattern after development may be further cleaned by using a washing solution. For use as the washing solution, ultrapure water, rinsing liquid, and the like may be used. The rinsing liquid is not particularly limited as long as it does not dissolve the resist pattern, and a solution containing a general organic solvent may be used. For example, the rinsing liquid may be an alcohol-based solvent or an ester-based solvent. After the washing, the rinsing liquid remaining on

the board and the pattern may be removed. In addition, when ultrapure water is used, the water remaining on the board and the pattern may be removed.

In addition, the developer may be used either individually or in a combination of two or more types.

After the resist pattern is formed as described above, a patterned interconnection board may be obtained. An etching method may be performed by known methods including: dry etching using plasma gas; wet etching using an alkali solution, a cupric chloride solution, a ferric chloride solution; and the like.

After forming the resist pattern, plating may be performed. Although not particularly limited, a plating method may include, for example, copper plating, solder plating, nickel plating, gold plating, and the like.

The resist pattern remaining after etching may be peeled with an organic solvent. Although not particularly limited, examples of the organic solvent may include propylene glycol monomethyl ether acetate (PGMEA) propylene glycol monomethyl ether (PGME), ethyl lactate (EL), and the like. Although not particularly limited, examples of the exfoliation method may are an immersion method, a spray method, and the like. In addition, the interconnection board on which the resist pattern is formed may be a multi-layer interconnection board or may have small-diameter through-holes.

In an embodiment, the interconnection board may be formed by a lift-off method in which a resist pattern is formed and then metal is deposited in a vacuum and then the resist pattern is dissolved by using a solution.

The disclosure will be described in more detail with reference to Examples and Comparative Examples below, but the technical scope of the disclosure is not limited only thereto.

**[Examples]**

**Synthesis Example 1: Synthesis of Polymer A**

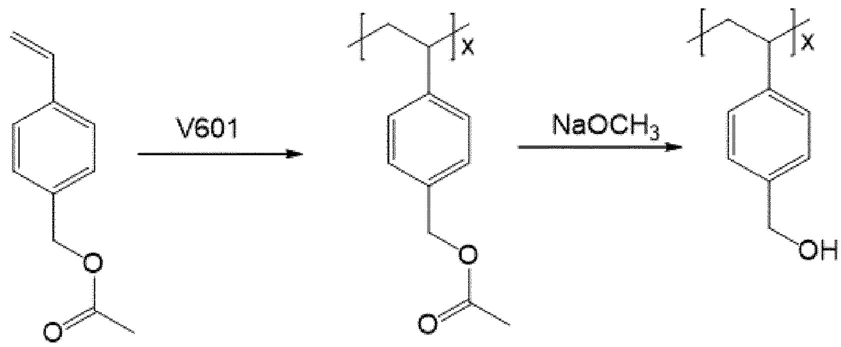


4 g (22.7 mmol) of 4-vinylbenzyl acetate (VBA, Monomer 1) and 0.5 g (2.3 mmol) of an azo initiator (V601) were dissolved in 35 % methylethylketone (MEK), and then reacted at 70 °C for 4 hours. Next, hexane was added thereto to allow precipitation, and the precipitate was dried to obtain a solid. The solid thus obtained was dispersed in methanol, and a $NaOCH_3$ solution (25 wt%, methanol) was added thereto in a molar ratio twice that of the obtained solid. Then, a reaction was allowed at room temperature for 4 hours to obtain a reaction product. Afterwards, 50 mL of distilled water (DW) and acetic acid (in a molar ratio twice that of the already added $NaOCH_3$) were added to the reaction product, and an extraction process was performed thereon by using ethyl acetate (EA), followed by precipitation by using hexane. The precipitate thus obtained was then dried at 40 °C for 24 hours to obtain white powdered Polymer A.

**Synthesis Examples 2 to 8**

Polymers were obtained in the same manner as in Synthesis Example 1, except that Monomers 1 to 3 of Table 1 were used instead of Monomer 1. For the polymers obtained in Synthesis Examples 1 to 8, $^1$H-NMR, weight average molecular weight, and PDI were measured, and the results are shown in Table 2.

[Table 1]

| | Polymer | Monomer | | | Monomer ratio (mol%) | | |
|---|---|---|---|---|---|---|---|
| | | Monomer 1 | Monomer 2 | Monomer 3 | Monomer 1 | Monomer 2 | Monomer 3 |
| Synthesis Example 1 | A | VBA | - | - | 100 | - | - |
| Synthesis Example 2 | B-1 | VBA | ECPMA | - | 80 | 20 | - |

(continued)

| | Polymer | Monomer | | | Monomer ratio (mol%) | | |
|---|---|---|---|---|---|---|---|
| | | Monomer 1 | Monomer 2 | Monomer 3 | Monomer 1 | Monomer 2 | Monomer 3 |
| Synthesis Example 3 | B-2 | VBA | ECPMA | | 60 | 40 | - |
| Synthesis Example 4 | B-3 | VBA | ECPMA | | 50 | 50 | - |
| Synthesis Example 5 | B-4 | VBA | ECPMA | | 40 | 60 | - |
| Synthesis Example 6 | C-1 | VBA | AHS | ECPMA | 40 | 10 | 50 |
| Synthesis Example 7 | C-2 | VBA | AHS | ECPMA | 25 | 25 | 50 |
| Synthesis Example 8 | C-3 | VBA | AHS | ECPMA | 10 | 40 | 50 |

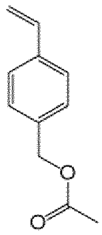

VBA

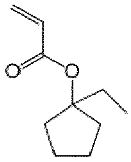

ECPMA

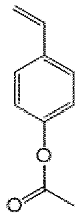

AHS

[Table 2]

| | Polymer | Monomer ratio ($^1$H-NMR) | | | Weight average molecular weight (Mw) | PDI |
|---|---|---|---|---|---|---|
| | | Monomer 1 | Monomer 2 | Monomer 3 | | |
| Synthesis Example 1 | A | 100 | - | - | 2,963 | 1.62 |
| Synthesis Example 2 | B-1 | 84 | 16 | - | 3,546 | 1.61 |
| Synthesis Example 3 | B-2 | 54 | 46 | - | 5,479 | 2.0 |
| Synthesis Example 4 | B-3 | 49 | 51 | - | 5,818 | 1.87 |
| Synthesis Example 5 | B-4 | 41 | 59 | - | 6,727 | 1.94 |
| Synthesis Example 6 | C-1 | 37 | 10 | 53 | 5,613 | 1.88 |
| Synthesis Example 7 | C-2 | 25 | 24 | 51 | 5,529 | 1.73 |
| Synthesis Example 8 | C-3 | 8 | 39 | 53 | 5,630 | 1.76 |

**Evaluation Example 1: Evaluation of thin film phenomenon**

**(1) Terminology**

$E_0$ represents an exposure dose at the point where a thin film begins to harden, and $E_1$ represents an exposure dose at a saturation point where a thin film no longer increases in thickness. The residual film ratio refers to a thin film thickness at a saturation point divided by the initial thickness, expressed as percentage, and $\gamma$ refers to a contrast curve value calculated by Equation 1:

Equation 1

$$\gamma = \left[\log\left(\frac{E_0}{E_1}\right)\right]^{-1}$$

NRT is an abbreviation for normalized remaining thickness.

**(2) Evaluation of thin film phenomenon**

In a solution containing propylene glycol methyl ether (PGME)/propylene glycol methyl ether acetate (PGMEA) at a ratio of 7:3 (wt/wt), the polymer, PAG A, and PDQ A of Table 3 were dissolved so that the sum of these materials was 1.5 wt%. Here, the weight ratio of the polymer, PAG A, and PDQ A was as shown in Table 3. A casting solution was spin-coated at 1,500 rpm on a silicon wafer coated with HMDS as a 3-mm-thick lower layer, and then dried at 130 °C for 1 minute to prepare a 50 nm-thick film. Next, the resulting film was exposed with DUV with a wavelength of 248 nm at a dose in a range of about 0 mJ/cm$^2$ to about 50 mJ/cm$^2$, followed by being subjected to PEB at 110 °C for 60 seconds. After soaking in a developer shown in Table 3 at 25 °C for 20 seconds, the thickness of the remaining film was measured by using a three-dimensional optical profiler (Bruker, Contour X-100), and the results are shown in Table 3 and FIGS. 3A to 3J. FIG. 3A shows a graph of data of Example 1-1, FIG. 3B shows a graph of data of Example 1-2, FIG. 3C shows a graph of data of Example 1-3, FIG. 3D shows a graph of data of Example 1-4, FIG. 3E shows a graph of data of Example 1-5, FIG. 3F shows a graph of data of Example 1-6, FIG. 3G shows a graph of data of Example 1-7, FIG. 3H shows a graph of data of Example 1-8, FIG. 3I shows a graph of data of Comparative Example 1-1, and FIG. 3J shows a graph of data of Comparative Example 1-2.

Table 3

| | Polymer | Weight ratio (Polymer: PAG A: PDQ A, wt%) | Developer | $E_0$ (mJ) | $E_1$ (mJ) | $\gamma$ | Residual film ratio (%) |
|---|---|---|---|---|---|---|---|
| Comparative Example 1-1 | E | 1.2: 0.2: 0.1 | PGMEA:AA=98:2 | 6.1 | 11.6 | 3.6 | 100 |
| Comparative Example 1-2 | D | 1.2: 0.2: 0.1 | n-BA | 11.5 | 38.6 | 1.9 | 83 |
| Example 1-1 | A | 1.2:0.2:0.1 | PGMEA:AA=98:2 | 9.4 | 15.6 | 5.3 | 98 |
| Example 1-2 | B-1 | 1.2:0.2:0.1 | PGMEA:AA=98:2 | 11.2 | 14.1 | 10.1 | 99 |
| Example 1-3 | B-2 | 1.2:0.2:0.1 | n-BA | 10.1 | 11.5 | 16.8 | 100 |
| Example 1-4 | B-3 | 1.2:0.2:0.1 | n-BA | 9.3 | 11.0 | 13.8 | 99 |
| Example 1-5 | B-4 | 1.2:0.2:0.1 | n-BA | 10.5 | 11.1 | 43.7 | 98 |
| Example 1-6 | C-1 | 1.2:0.2:0.1 | n-BA | 8.5 | 9.3 | 23.8 | 100 |
| Example 1-7 | C-2 | 1.2:0.2:0.1 | n-BA | 7.6 | 9.1 | 12.2 | 98 |
| Example 1-8 | C-3 | 1.2:0.2:0.1 | n-BA | 6.7 | 8.0 | 12.7 | 97 |

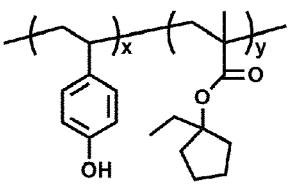

**D, x:y = 50:50**

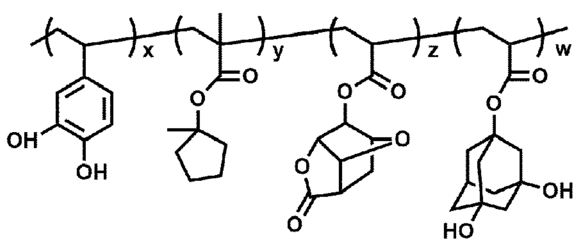

**E, x:y:z:w = 31:49:13:7**

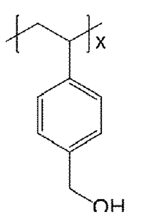

**A, x = 100**

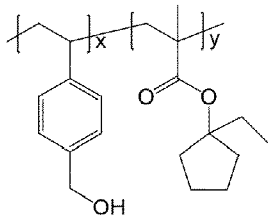

**B-1, x:y = 84:16**
**B-2, x:y = 54:46**
**B-3, x:y = 49:51**
**B-4, x:y = 41:59**

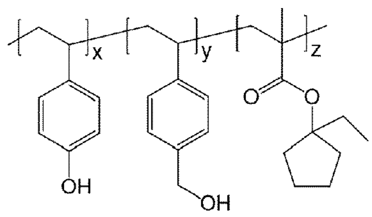

**C-1, x:y:z = 37:10:53**
**C-2, x:y:z = 25:24:51**
**C-3, x:y:z = 8:39:53**

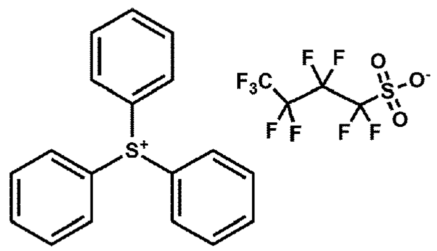

**PAG A**

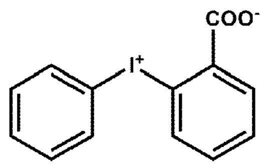

**PDQ A**

Referring to Table 3, it was confirmed that the thin films of Examples 1-1 to 1-8 had the smaller $E_1$ value and the larger $\gamma$ value than the thin film of Comparative Example 1-2, suggesting that the thin films of Examples 1-1 to 1-8 had improved sensitivity compared to the thin film of Comparative Example 1-2.

In addition, it was confirmed that the thin films of Example 1-2 to 1-5 had the larger $\gamma$ value than the thin film of Example 1-1, and that the thin films of Examples 1-6 to 1-8 had the smaller $E_{th}$ value than the thin film of Example 1-1.

**Evaluation Example 2: Evaluation results of elastic modulus**

A test sample was prepared by cutting a silicon wafer coated with the polymers of Table 4 into a size of 10 mm×10 mm. By using Bruker's Dimension Icon XR and RTESPA-300-30 probes, the elastic modulus of the thin films was measured in a tapping mode under conditions of a tip radius of 30nm and a spring constant of 40 N/m. The results thereof are shown in Table 4.

Table 4

| | Polymer | Elastic modulus (MPa) | Relative value (%) |
|---|---|---|---|
| Comparative Example 2-1 | D | 2,745 | 100 |
| Example 2-1 | A | 3,182 | 116 |
| Example 2-2 | B-1 | 4,307 | 157 |
| Example 2-3 | B-2 | 3,763 | 137 |
| Example 2-4 | B-3 | 3,534 | 129 |
| Example 2-5 | B-4 | 3,243 | 118 |
| Example 2-6 | C-1 | 3,988 | 145 |
| Example 2-7 | C-2 | 3,982 | 145 |
| Example 2-8 | C-3 | 3,666 | 134 |

It was confirmed that the elastic modulus of the thin films of Examples 2-1 to 2-8 was improved by about 16% to 57%, specifically up to 57 % compared to the elastic modulus of the thin film of Comparative Example 2-1. Although not limited to a specific theory, Polymers A, B-1 to B-4, and C-1 to C-3 were cross-linked, and thus the elastic modulus of these polymers was improved compared to Polymer D which was not cross-linked.

**Evaluation Example 3: Evaluation of etch resistance**

By using a dry etching apparatus, Plasmalab 100 RIE (purchased by Oxford Instruments Plasma Technology), the thin films were etched with etching gas of $CF_4$ and $O_2$ at a gas flow rate of 20:5 (sccm) for 10 seconds, 20 seconds, and 30 seconds, under conditions of an output of 50 W and a pressure of 30 mtorr. Then, the etching rate was measured from the thickness variation, and the results thereof are shown in Table 5.

Table 5

| | Polymer | Etching rate (nm/s) | Relative value (%) |
|---|---|---|---|
| Comparative Example 3-1 | D | 1.105 | 100 |
| Example 3-1 | A | 0.757 | 69 |
| Example 3-2 | B-1 | 0.928 | 84 |
| Example 3-3 | B-2 | 0.925 | 84 |
| Example 3-4 | B-3 | 0.944 | 85 |
| Example 3-5 | B-4 | 0.828 | 75 |
| Example 3-6 | C-1 | 0.988 | 89 |
| Example 3-7 | C-2 | 0.996 | 90 |
| Example 3-8 | C-3 | 1.004 | 91 |

It was confirmed that the etching rate of the thin film of Examples 3-1 to 3-8 was reduced by about 9 % to 31 %, specifically up to 31 % compared to the etching rate of the thin film of Comparative Example 3-1. Although not limited to a specific theory, Polymers A, B-1 to B-4, and C-1 to C-3 were cross-linked, and thus the etching rate thereof was expected to slow down compared to Polymer D which was not cross-linked.

FIGS. 4A to 4E are side cross-sectional views illustrating a method of forming a patterned structure according to an embodiment.

Referring to FIG. 4A, a material layer 130 may be formed on the substrate 100 before forming a resist film 110 on the substrate 100. The resist film 110 may be formed on top of the material layer 130. The material layer 130 may include an insulating material (e.g., silicon oxide, silicon nitride), a semiconductor material (e.g., silicon), a metal (e.g., copper). In some embodiments, the material layer 130 may be a multi-layer structure. A material of the material layer 130 may be different than a material of the substrate 100. The resist film 110 may include a resist composition according to example embodiments and may have a thickness of about 10 nm to about 300 nm or about 30 nm to about 200 nm.

Referring to FIG. 4B, the resist film 110 may be exposed with high energy rays through a mask 120, after which the resist film 110 may include exposed regions 111 and unexposed regions 112.

Referring to FIG. 4C, the exposed resist film 110 may be developed using a developer (e.g., developing solution). The exposed portion 111 may remain without being washed away by the developing solution, whereas the non-exposed portion 112 may be washed away by the developing solution.

Referring to FIG. 4D, exposed areas of the material layer 130 may be etched using the resist pattern 110 as a mask to form a material pattern 135 on the substrate 100.

Referring to FIG. 4E, the resist pattern 110 may be removed.

FIGS. 5A to 5E are side cross-sectional views illustrating a method of forming a semiconductor device according to an embodiment.

Referring to FIG. 5A, a gate dielectric 505 (e.g., silicon oxide) may be formed on a substrate 500. The substrate 500 may be a semiconductor substrate, such as a silicon substrate. A gate layer 515 (e.g., doped polysilicon) may be formed on the gate dielectric 505. A hardmask layer 520 may be formed on the gate layer 515.

Referring to FIG. 5B, a resist pattern 540b may be formed on the hardmask layer 520. The resist pattern 540b may be formed using a resist composition according to example embodiments. The resist pattern 540b may be formed from a resist composition including the polymer, a photoacid generator, an organic solvent, and optionally a quencher and a base resin.

Referring to FIG. 5C, the gate layer 515 and the gate dielectric 505 may be etched to form a hardmask pattern 520a, a gate electrode pattern 515a, and a gate dielectric pattern 505a.

Referring to FIG. 5D, a spacer layer may be formed over the gate electrode pattern 515a and the gate dielectric pattern 505a. The spacer layer may be formed using a deposition process (e.g., CVD). The spacer layer may be etched to form spacers 535a (e.g., silicon nitride) on sidewalls of the gate electrode pattern 515a and the gate dielectric pattern 505a.

After forming the spacers 535a, ions may be implanted into the substrate 500 to form source/drain impurity regions S/D.

Referring to FIG. 5E, an interlayer insulating layer 560 (e.g., oxide) may be formed on the substrate 500 to cover the gate electrode pattern 515a, gate dielectric pattern 505a, and spacers 535a. Then, electrical contacts 570a, 570b, and 570c may be formed in the interlayer insulating layer 560 to connect to the gate electrode 515a and the S/D regions. The electrical contacts may be formed of a conductive material (e.g., metal). Although not illustrated, a barrier layer may be formed between sidewalls of the interlayer insulating layer 560 and the electrical contacts 570a, 570b, and 570c. While FIGS. 5A to 5E illustrate an example of forming a transistor, inventive concepts are not limited thereto.

A resist composition according to one or more embodiments may be used in a patterning process to form other types of semiconductor devices.

According to the one or more embodiments, examples of the disclosure may provide a resist composition capable of providing improved sensitivity and/or improved resolution.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

**1.** A polymer comprising a first repeating unit represented by Formula 1:

Formula 1

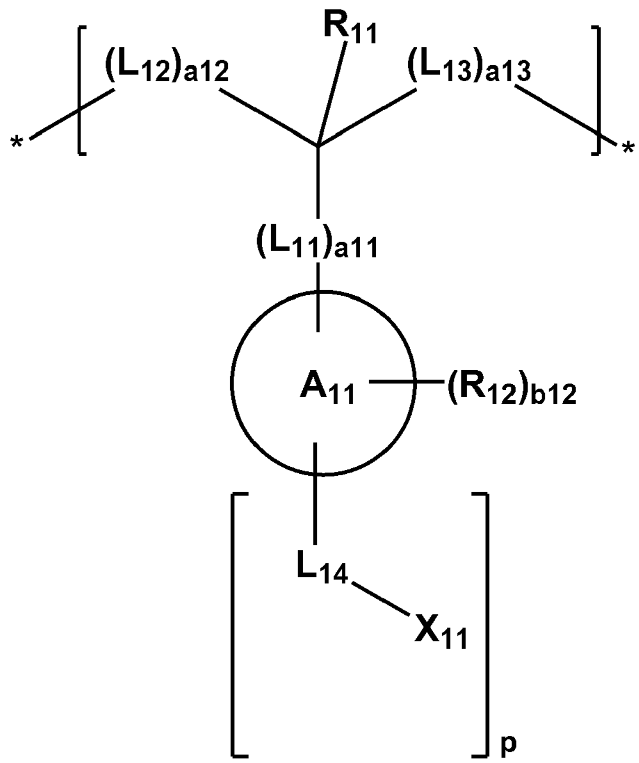

wherein, in Formula 1,

$L_{11}$ to $L_{13}$ are each independently: a single bond; O; S; C(=O); C(=O)O; OC(=O); C(=O)NH; NHC(=O); or a linear, branched, or cyclic $C_1$-$C_{30}$ divalent hydrocarbon group that optionally includes a heteroatom,
$L_{14}$ is a linear, branched, or cyclic $C_1$-$C_{30}$ divalent hydrocarbon group that optionally includes a heteroatom,
a11 to a13 are each independently an integer from 1 to 4,
$A_{11}$ is a $C_6$-$C_{30}$ aromatic group or a $C_1$-$C_{30}$ heteroaromatic group,
$R_{11}$ and $R_{12}$ are each independently: hydrogen; deuterium; a halogen; a cyano group; a hydroxy group; an amino group; a carboxylic acid group; a thiol group; an ester moiety; a sulfonate ester moiety; a carbonate moiety; a

lactone moiety; a sultone moiety; a carboxylic anhydride moiety; or a linear, branched, or cyclic $C_1$-$C_{30}$ monovalent hydrocarbon group that optionally includes a heteroatom,
b12 is an integer from 1 to 10,
$X_{11}$ is OH, SH, or $NH_2$,
p is an integer from 1 to 5, and
* indicates a binding site to a neighboring atom.

**2.** The polymer of claim 1, wherein

$L_{11}$ to $L_{13}$ are each independently: a single bond; O; S; C(=O); C(=O)O; OC(=O); C(=O)NH; NHC(=O); a substituted or unsubstituted $C_1$-$C_{30}$ alkylene group; a substituted or unsubstituted $C_3$-$C_{30}$ cycloalkylene group; a substituted or unsubstituted $C_3$-$C_{30}$ heterocycloalkylene group; a substituted or unsubstituted $C_2$-$C_{30}$ alkenylene group; a substituted or unsubstituted $C_3$-$C_{30}$ cycloalkenylene group; a substituted or unsubstituted $C_3$-$C_{30}$ heterocycloalkenylene group; a substituted or unsubstituted $C_6$-$C_{30}$ arylene group; or a substituted or unsubstituted $C_1$-$C_{30}$ heteroarylene group, and
$L_{14}$ is: a substituted or unsubstituted $C_1$-$C_{30}$ alkylene group; a substituted or unsubstituted $C_3$-$C_{30}$ cycloalkylene group; a substituted or unsubstituted $C_3$-$C_{30}$ heterocycloalkylene group; a substituted or unsubstituted $C_2$-$C_{30}$ alkenylene group; a substituted or unsubstituted $C_3$-$C_{30}$ cycloalkenylene group; a substituted or unsubstituted $C_3$-$C_{30}$ heterocycloalkenylene group; a substituted or unsubstituted $C_6$-$C_{30}$ arylene group; or a substituted or unsubstituted $C_1$-$C_{30}$ heteroarylene group.

**3.** The polymer of claims 1 or 2, wherein $A_{11}$ is a benzene group, a naphthalene group, a phenanthrene group, an anthracene group, a chrysene group, a pyrene group, a triphenylene group, a fluorene group, a pyrrole group, a pyridine group, a pyrimidine group, a pyrazine group, a triazine group, a quinoline group, an isoquinoline group, a carbazole group, a furan group, a benzofuran group, a dibenzofuran group, a thiophene group, a benzothiophene group, or a dibenzothiophene group; and/or
wherein $X_{11}$ is OH.

**4.** The polymer of any of claims 1-3, wherein the first repeating unit is represented by Formula 1-1:

Formula 1-1

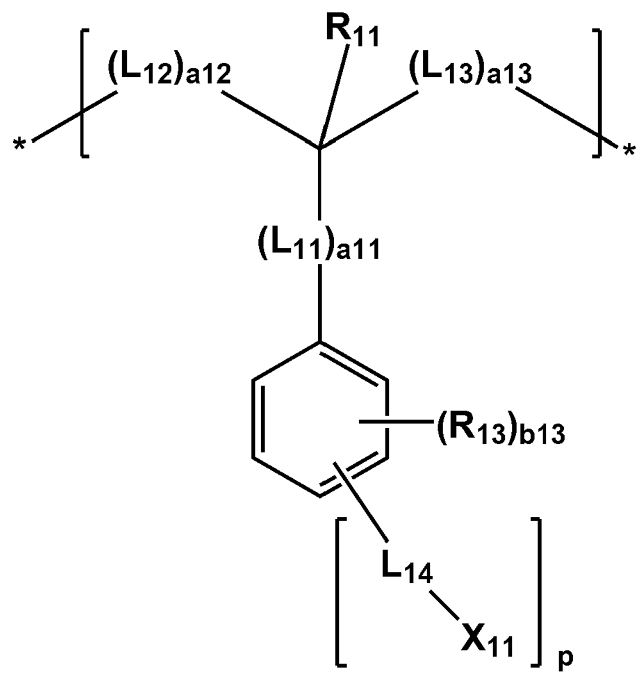

wherein, in Formula 1-1,

$L_{11}$ to $L_{14}$, a11 to a13, $X_{11}$, $R_{11}$, and p are each as defined in Formula 1,

$R_{13}$ is hydrogen, deuterium, a halogen, a cyano group, a hydroxy group, an amino group, a carboxylic acid group, a thiol group, an ester moiety, a sulfonate ester moiety, a carbonate moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_3$-$C_{20}$ cycloalkyl group, a $C_3$-$C_{20}$ cycloalkoxy group, or a $C_6$-$C_{20}$ aryl group,
b 13 is an integer from 1 to 5, and
* indicates a binding site to a neighboring atom;
preferably wherein the first repeating unit is selected from Group I:

Group I

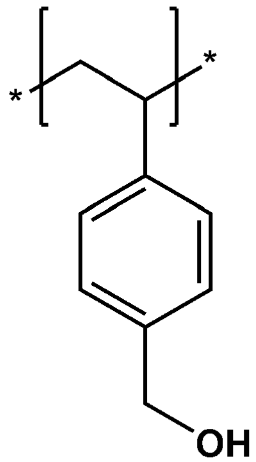

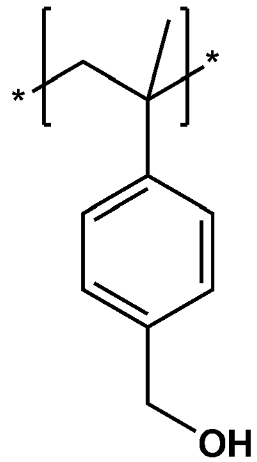

.

**5.** The polymer of any of claims 1-4, further comprising:

at least one of a second repeating unit represented by Formula 2 and a third repeating unit represented by Formula 3,

Formula 2

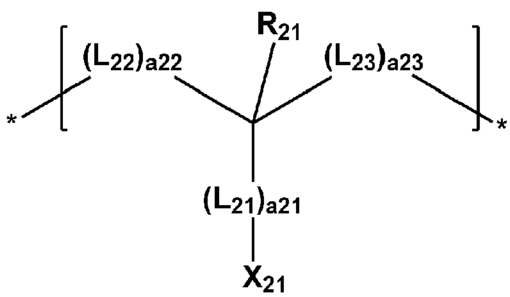

Formula 3

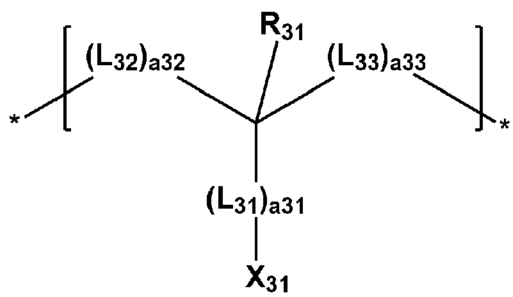

wherein, in Formulae 2 and 3,
$L_{21}$ to $L_{23}$ and $L_{31}$ to $L_{33}$ are each independently: a single bond; O; C(=O); C(=O)O; OC(=O); C(=O)NH; NHC(=O); or a linear, branched, or cyclic $C_1$-$C_{30}$ divalent hydrocarbon group that optionally includes a heteroatom,
a21 to a23 and a31 to a33 are each independently an integer from 1 to 4,
$R_{21}$ and $R_{31}$ are each independently: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{30}$ monovalent hydrocarbon group that optionally includes a heteroatom,
$X_{21}$ is an acid labile group,
$X_{31}$ is a non-acid labile group, and
* indicates a binding site to a neighboring atom.

**6.** The polymer of claim 5, wherein

the polymer includes the second repeating unit represented by Formula 2, and

$X_{21}$ is represented by Formula 4-1 or 4-2:

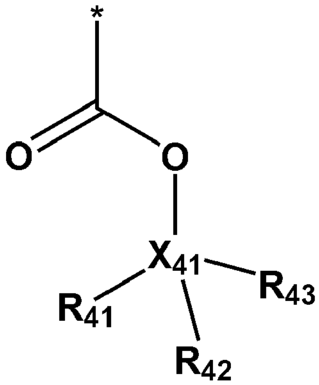

4-1

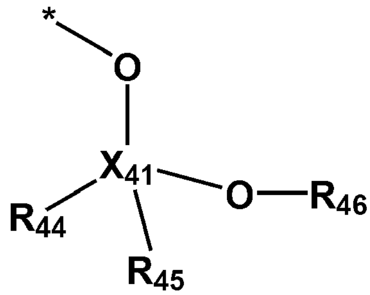

4-2

wherein, in Formulae 4-1 and 4-2,
$X_{41}$ is a carbon atom or a silicon atom,
$R_{41}$ to $R_{45}$ are each independently: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{30}$ monovalent hydrocarbon group that optionally includes a heteroatom,
$R_{46}$ is a linear, branched, or cyclic $C_1$-$C_{30}$ monovalent hydrocarbon group that optionally includes a heteroatom,
an adjacent two of $R_{41}$ to $R_{46}$ are optionally bonded to each other to form a ring, and
* indicates a binding site to a neighboring atom.

**7.** The polymer of claims 5 or 6, wherein

the polymer includes the second repeating unit represented by Formula 2, and
$X_{21}$ is selected from groups represented by Formulae 5-1 to 5-11:

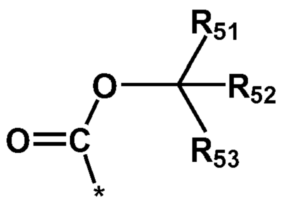

5-1

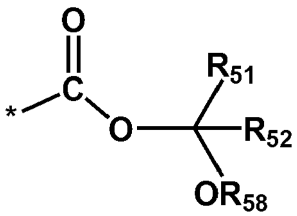

5-2

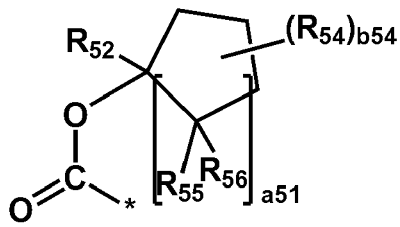

5-3

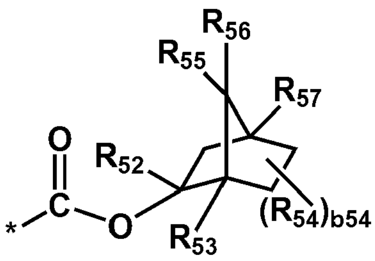

5-4

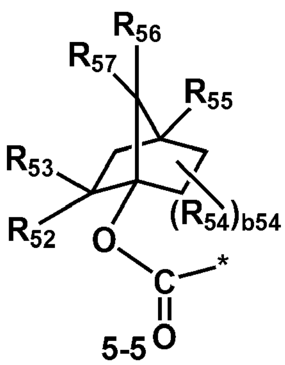

5-5

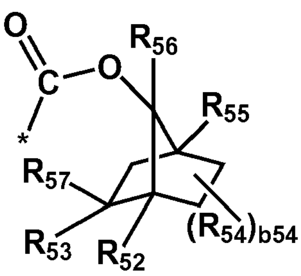

5-6

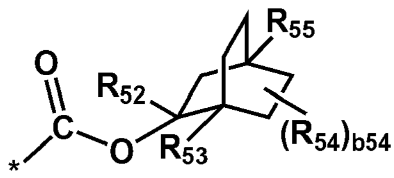

**5-7**

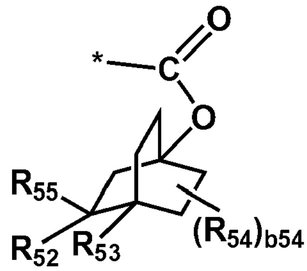

**5-8**

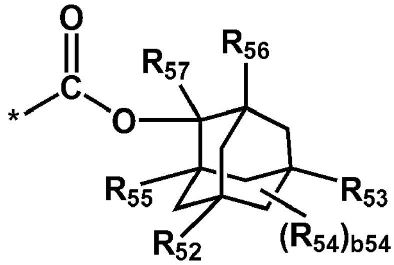

**5-9**

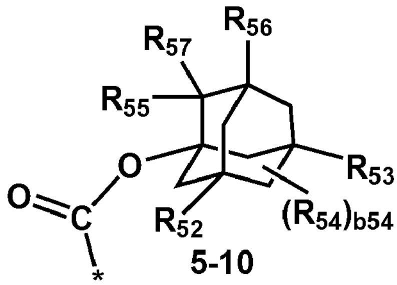

**5-10**

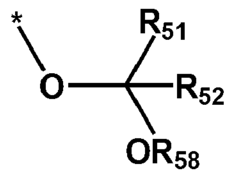

**5-11**

wherein, in Formulae 5-1 to 5-11,
a51 is an integer selected from 0 to 6,
$R_{51}$ and $R_{58}$ are each independently a linear, branched, or cyclic $C_1$-$C_{20}$ monovalent hydrocarbon group that optionally includes a heteroatom,
$R_{52}$ to $R_{57}$ are each independently: hydrogen; deuterium; a halogen; a cyano group; a hydroxy group; an amino group; a carboxylic acid group; a thiol group; an ester moiety; a sulfonate ester moiety; a carbonate moiety; a lactone moiety; a sultone moiety; a carboxylic anhydride moiety; or a linear, branched, or cyclic $C_1$-$C_{20}$ monovalent hydrocarbon group that optionally includes a heteroatom,
an adjacent two of $R_{51}$ to $R_{58}$ are optionally bonded to each other to form a ring,
b54 is an integer from 1 to 10, and
* indicates a binding site to a neighboring atom.

**8.** The polymer of any of claims 5-7, wherein

the polymer includes the second repeating unit represented by Formula 2, and
the second repeating unit is one of or two or more selected from Group II:

Group II

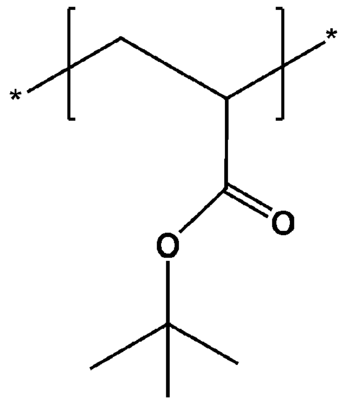
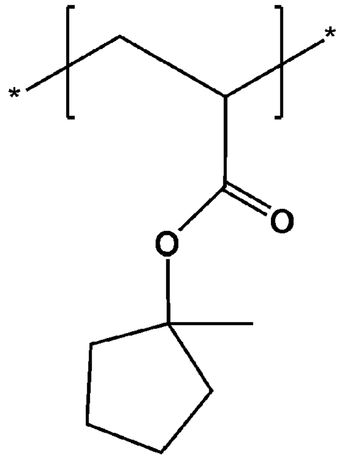
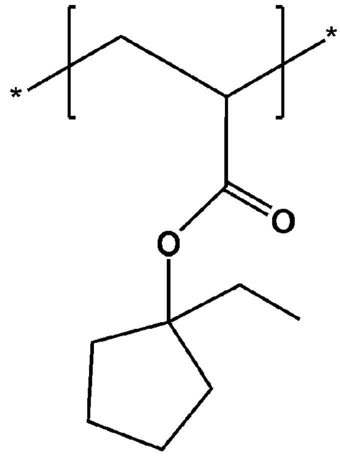
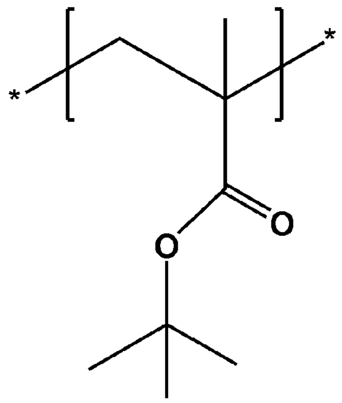
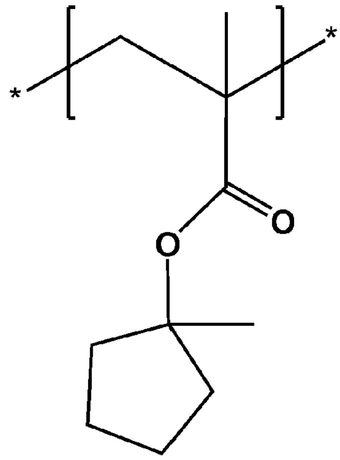
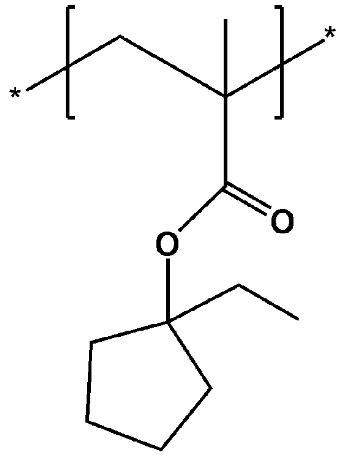

.

**9.** The polymer of any of claims 5-8, wherein

the polymer includes the second repeating unit represented by Formula 3, and
$X_{31}$ is: hydrogen; a halogen; a cyano group; a hydroxy group; a carboxylic acid group; a thiol group; an amino group; or a linear, branched, or cyclic $C_1$-$C_{30}$ monovalent hydrocarbon group that optionally includes one or more polar moieties selected from a halogen, a cyano group, a hydroxy group, a thiol group, a carboxylic acid group, O, C=O, C(=O)O, OC(=O), S(=O)O, OS(=O), a lactone moiety, a sultone moiety, and a carboxylic anhydride moiety.

**10.** The polymer of any of claims 5-9, wherein

the polymer includes the second repeating unit represented by Formula 3, and
$X_{31}$ is: hydrogen; a hydroxy group; or a group represented by one of Formulae 6-1 to 6-10:

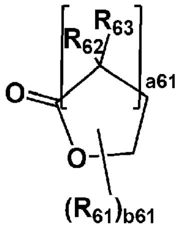
6-1
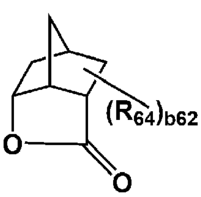
6-2
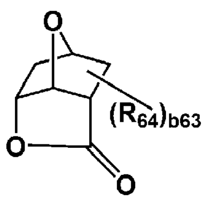
6-3
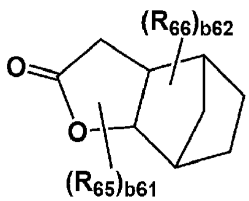
6-4
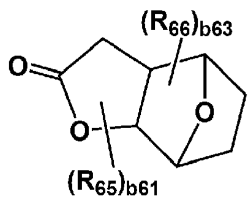
6-5

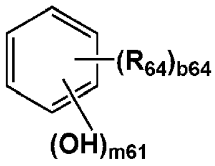

6-6

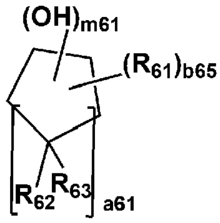

6-7

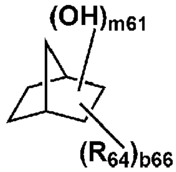

6-8

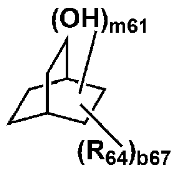

6-9

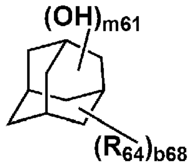

6-10

wherein, in Formulae 6-1 to 6-10,
a61 is 1 or 2,
$R_{61}$ to $R_{66}$ are each independently: a binding site to a neighboring atom; hydrogen; a hydroxy group; a carboxylic acid group; an ester moiety; a carbonate moiety; a lactone moiety; a carboxylic anhydride moiety; or a linear, branched, or cyclic $C_1$-$C_{20}$ monovalent hydrocarbon group,
one of $R_{61}$ to $R_{63}$, one of $R_{64}$, and one of $R_{65}$ and $R_{66}$ are each a binding site to a neighboring atom,
b61 is an integer from 1 to 4,
b62 is an integer from 1 to 10,
b63 is an integer from 1 to 8,
b64 is an integer from 1 to 5,
b65 is an integer from 1 to 7,
b66 is an integer from 1 to 11,
b67 is an integer from 1 to 13,
b68 is an integer from 1 to 15, and
m61 is an integer from 1 to 4.

**11.** The polymer of any of claims 7-10, wherein

the polymer includes the second repeating unit represented by Formula 3, and
the third repeating unit is one of or two or more selected from Group III:

Group III

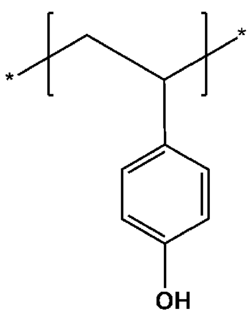

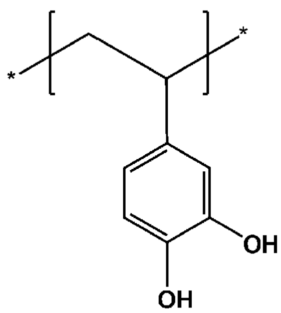

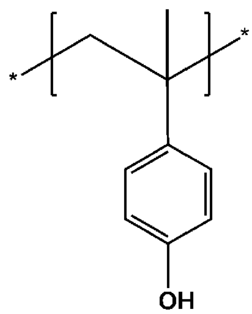

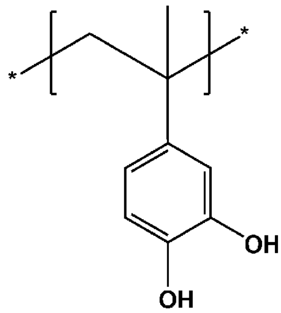

.

**12.** A resist composition comprising:

The polymer of any of claims 1-11;
a photoacid generator; and
an organic solvent;
preferably wherein the photoacid generator is represented by Formula 7:

Formula 7 $B_{71}^{+}\ A_{71}^{-}$

wherein, in Formula 7,
$B_{71}^{+}$ is represented by Formula 7A, and $A_{71}^{-}$ is represented by one of Formulae 7B to 7D, and

$B_{71}^{+}$ and $A_{71}^{-}$ are optionally linked to each other via a carbon-carbon covalent bond:

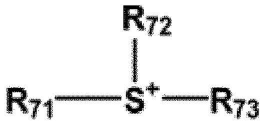

7A

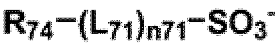

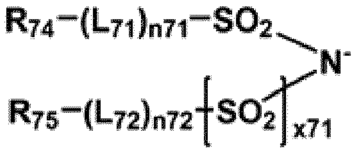

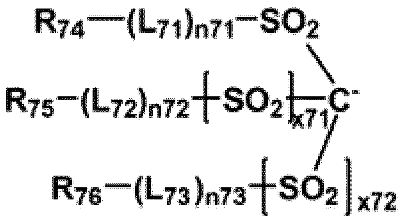

7B 7C 7D

wherein, in Formulae 7A to 7D,

$L_{71}$ to $L_{73}$ are each independently a single bond or CRR',

R and R' are each independently hydrogen, deuterium, a halogen, a cyano group, a hydroxy group, a $C_1$-$C_{30}$ alkyl group, a $C_1$-$C_{30}$ halogenated alkyl group, a $C_1$-$C_{30}$ alkoxy group, a $C_3$-$C_{30}$ cycloalkyl group, or a $C_3$-$C_{30}$ cycloalkoxy group,

n71 to n73 are each independently 1, 2, or 3,

x71 and x72 are each independently 0 or 1,

$R_{71}$ to $R_{73}$ are each independently a linear, branched, or cyclic $C_1$-$C_{30}$ monovalent hydrocarbon group that optionally includes a heteroatom,

an adjacent two of $R_{71}$ to $R_{73}$ are optionally bonded to each other to form a condensed ring, and

$R_{74}$ to $R_{76}$ are each independently: hydrogen; a halogen; or a linear, branched, or cyclic $C_1$-$C_{30}$ monovalent hydrocarbon group that optionally includes a heteroatom.

**13.** The resist composition of claim 12, further comprising a quencher, preferably wherein the quencher is represented by Formula 8:

Formula 8 $B_{81}^{+}\ A_{81}^{-}$

wherein, in Formula 8,

$B_{81}^{+}$ is represented by one of Formulae 8A to 8C,

$A_{81}^{-}$ is represented by one of Formulae 8D to 8F, and

$B_{81}^{+}$ and $A_{81}^{-}$ are optionally linked to each other via a carbon-carbon covalent bond:

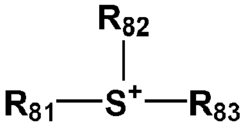

8A

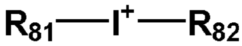

8B

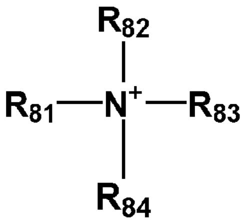

8C

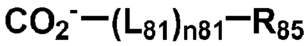

8D

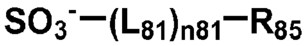

8E

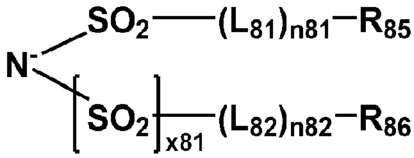

8F

wherein, in Formulae 8A to 8F,
$L_{81}$ and $L_{82}$ are each independently a single bond or CRR',
R and R' are each independently hydrogen, deuterium, a halogen, a cyano group, a hydroxy group, a $C_1$-$C_{30}$ alkyl group, a $C_1$-$C_{30}$ halogenated alkyl group, a $C_1$-$C_{30}$ alkoxy group, a $C_3$-$C_{30}$ cycloalkyl group, or a $C_3$-$C_{30}$ cycloalkoxy group,
n81 and n82 are each independently 1, 2, or 3,
x81 is 0 or 1,
$R_{81}$ to $R_{84}$ are each independently a linear, branched, or cyclic $C_1$-$C_{30}$ monovalent hydrocarbon group that optionally includes a heteroatom,
an adjacent two of $R_{81}$ to $R_{84}$ are optionally linked to each other to form a condensed ring, and
$R_{85}$ and $R_{86}$ are each independently: hydrogen; a halogen; or a linear, branched, or cyclic $C_1$-$C_{30}$ monovalent hydrocarbon group that optionally includes a heteroatom.

**14.** A method of forming a pattern, the method comprising:

forming a resist film by applying the resist composition of claims 12 or 13 onto a substrate;
exposing at least a portion of the resist film to high-energy rays to provide an exposed resist film; and
developing the exposed resist film using a developer.

**15.** The method of claim 14, wherein the exposing at least a portion of the resist film is performed by irradiating the resist film using at least one of ultraviolet rays, deep ultraviolet (DUV) rays, extreme ultraviolet (EUV) rays, X rays, $\gamma$ rays, an electron beam (EB), or $\alpha$ rays; and/or

wherein the method further comprises
heating the exposed resist film, after the exposing at least a portion of the resist film is performed,
wherein, during the heating the exposed resist film, cross-linking is formed in the polymer.

# FIG. 1

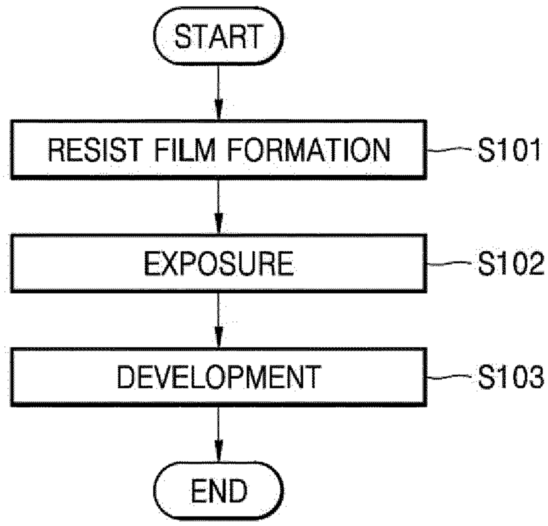
START
RESIST FILM FORMATION
S101
EXPOSURE
S102
DEVELOPMENT
S103
END

# FIG. 2A

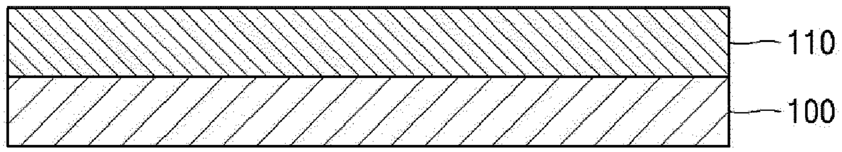

# FIG. 2B

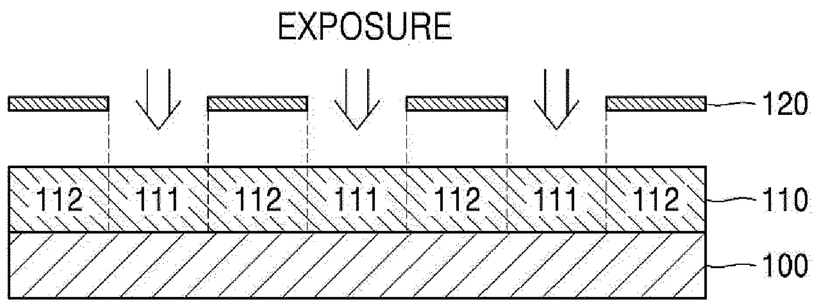

# FIG.2C

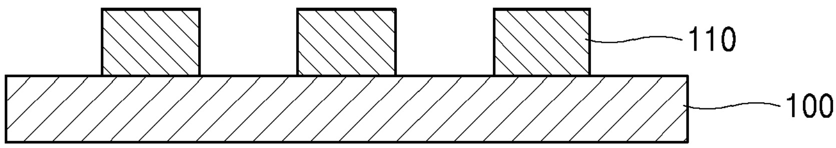

FIG. 3A

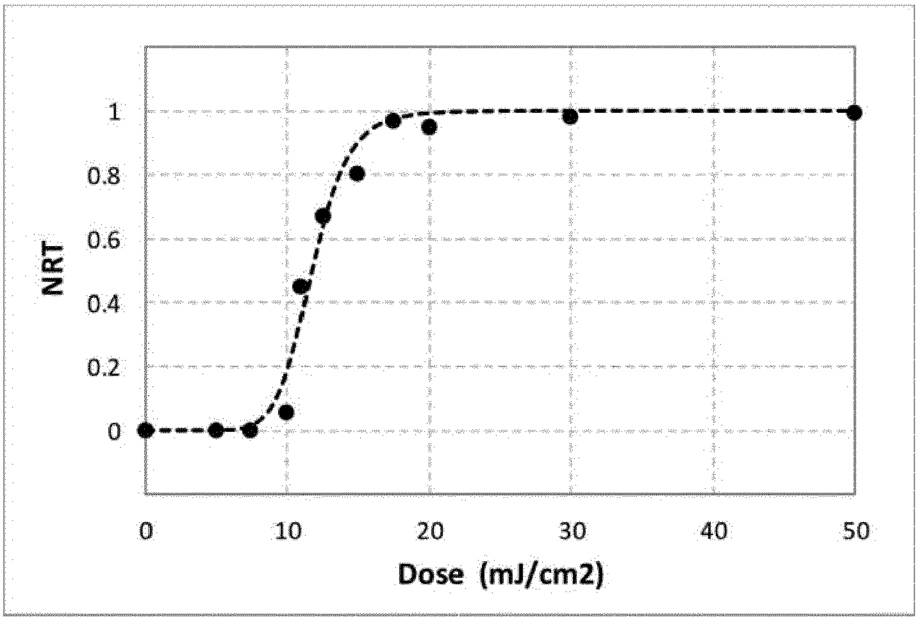

# FIG. 3B

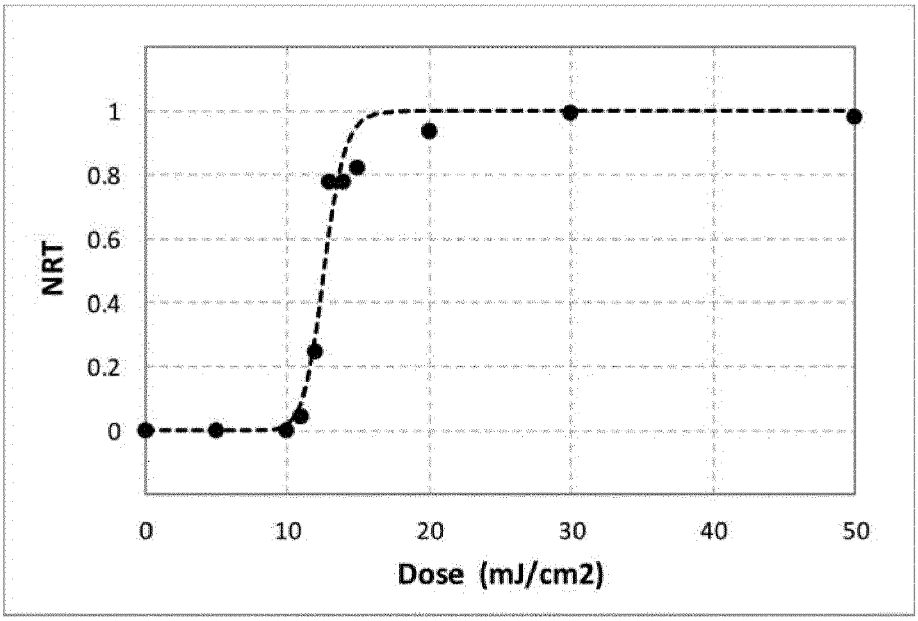

# FIG. 3C

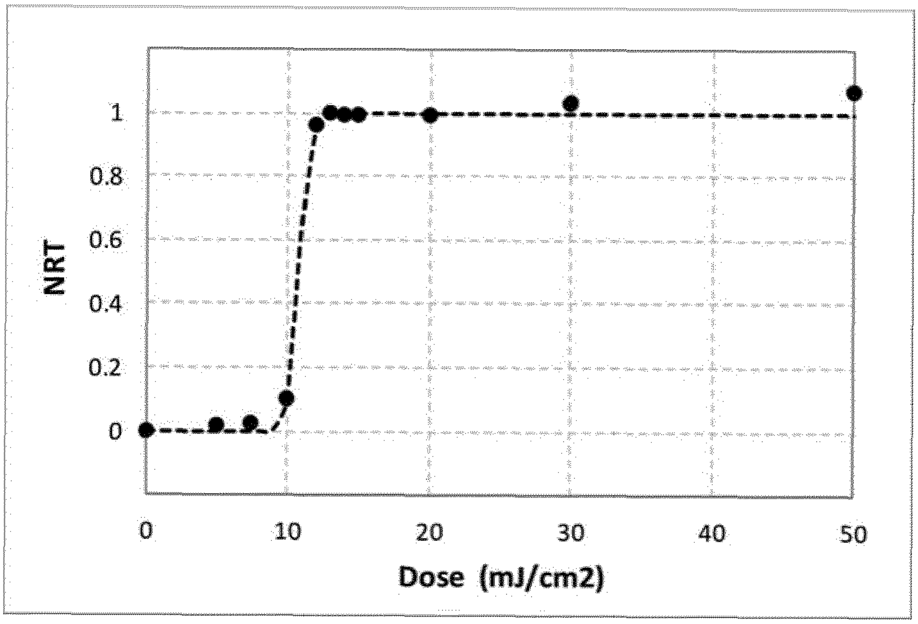

# FIG. 3D

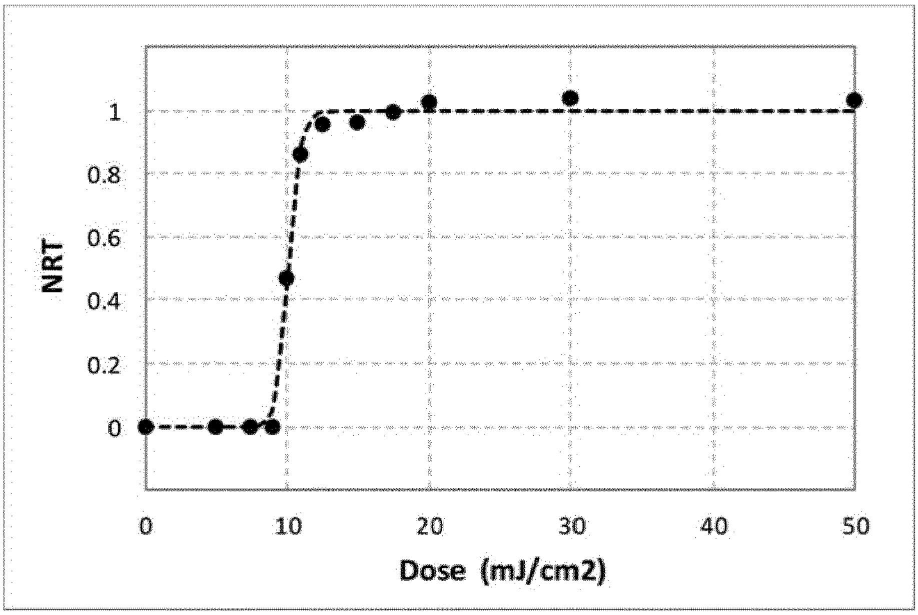

# FIG. 3E

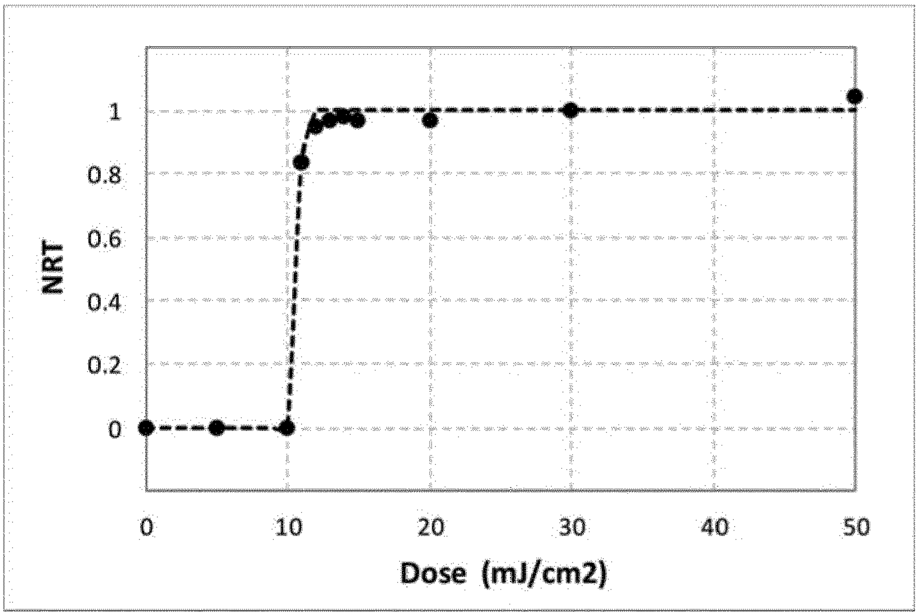

# FIG. 3F

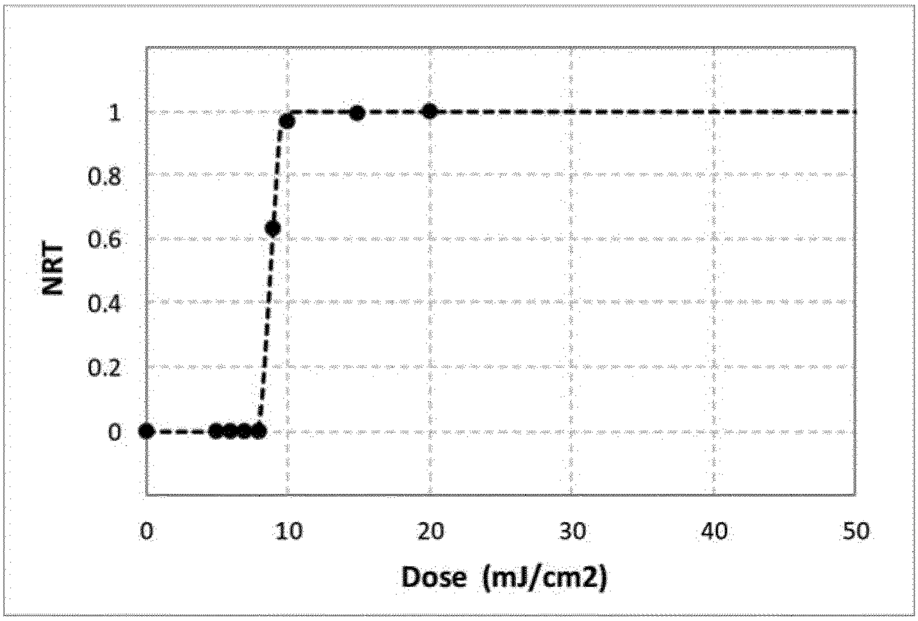

# FIG. 3G

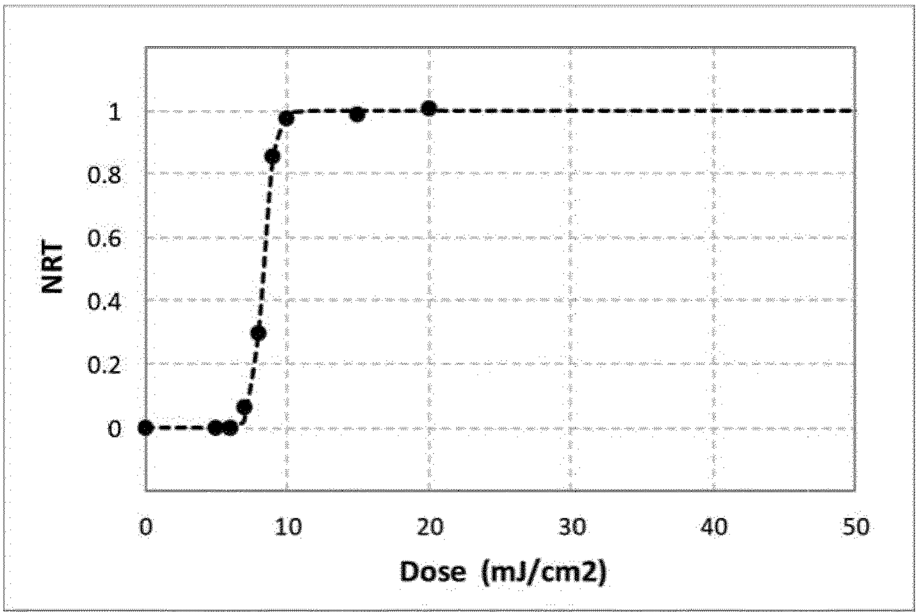

# FIG. 3H

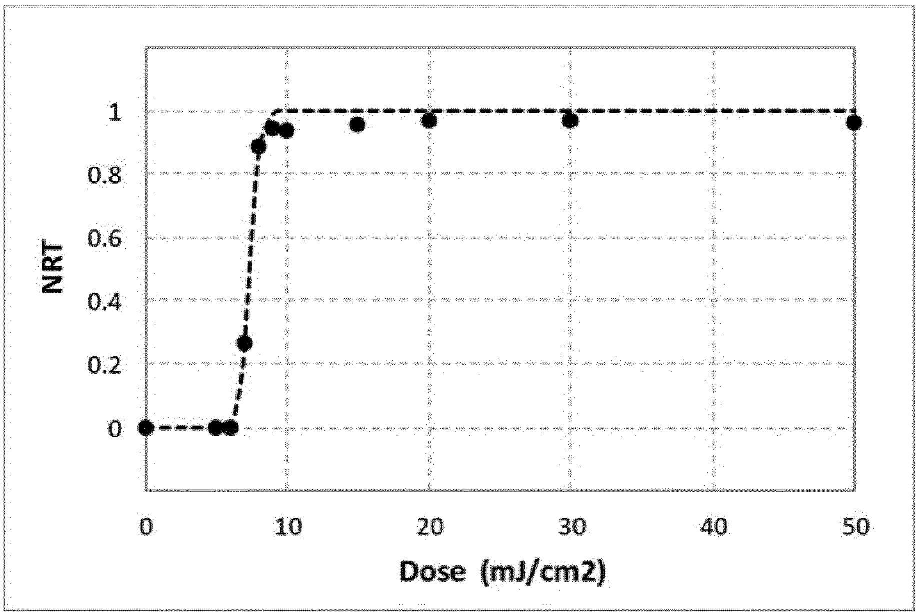

# FIG. 3I

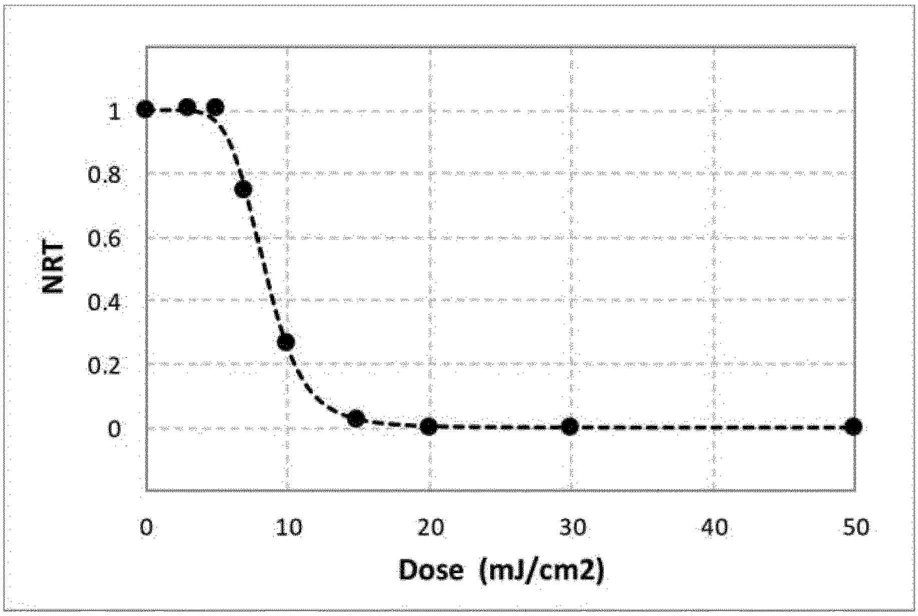

# FIG. 3J

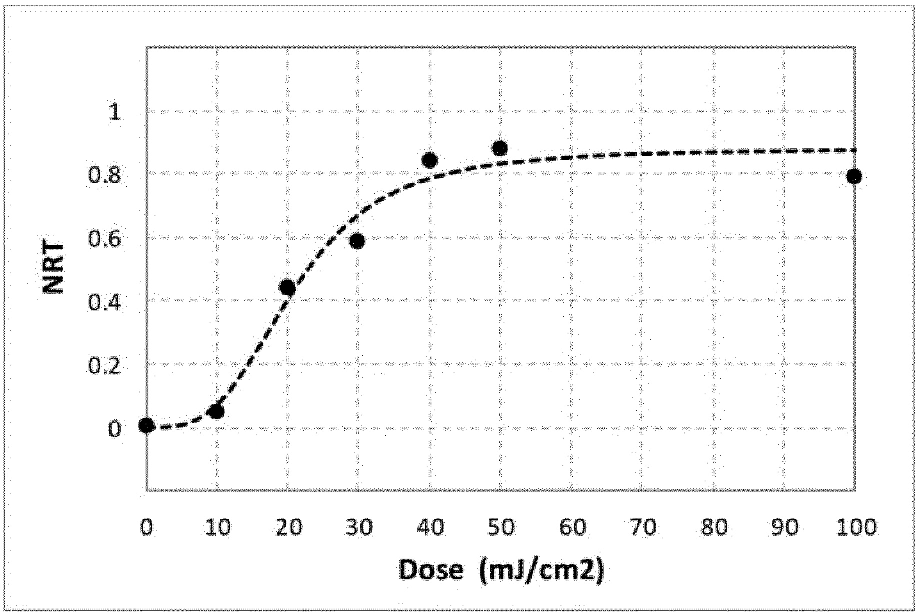

# FIG. 4A

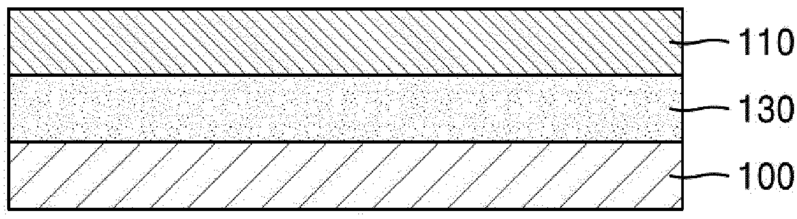

# FIG. 4B

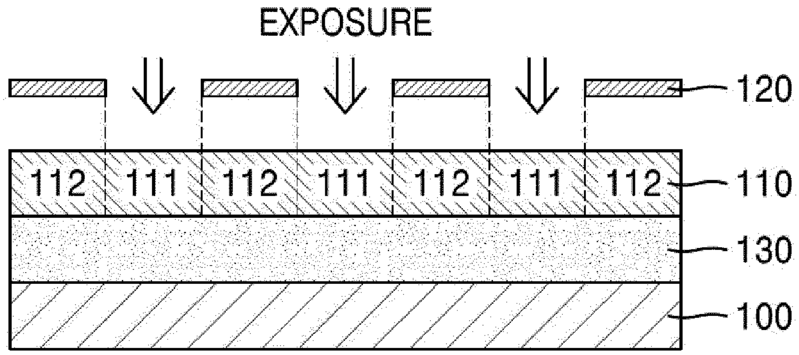

# FIG. 4C

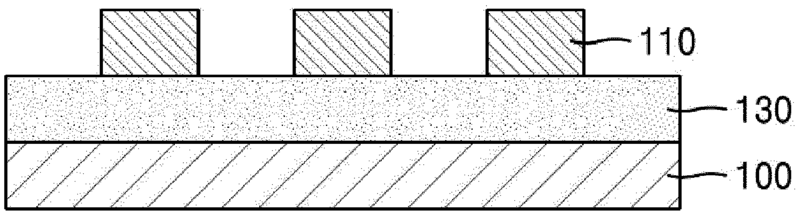

FIG. 4D

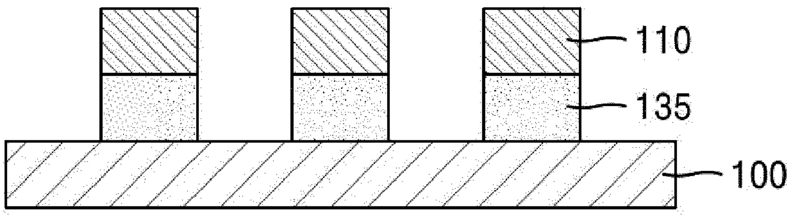

FIG. 4E

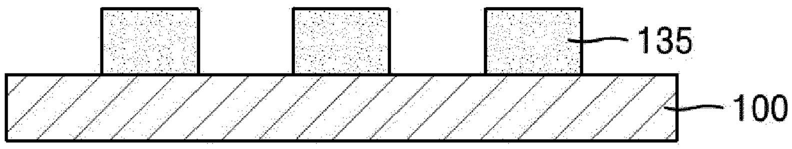

# FIG. 5A

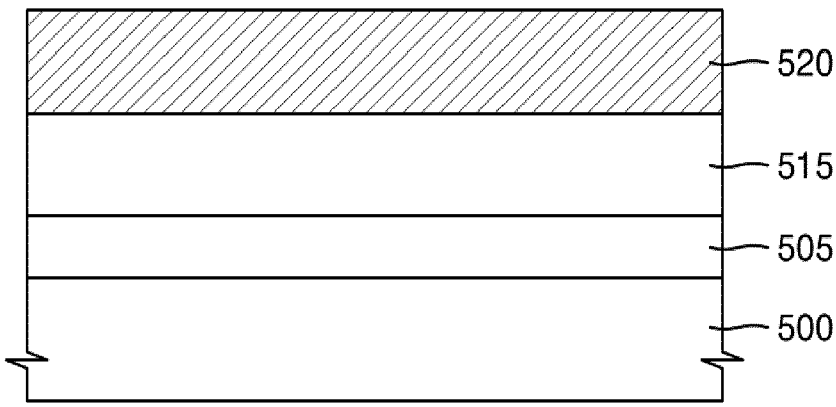

FIG. 5B

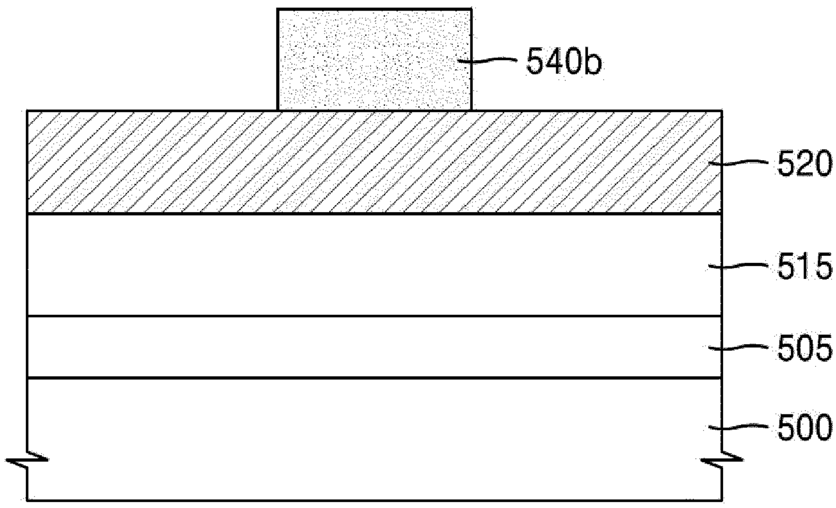

FIG. 5C

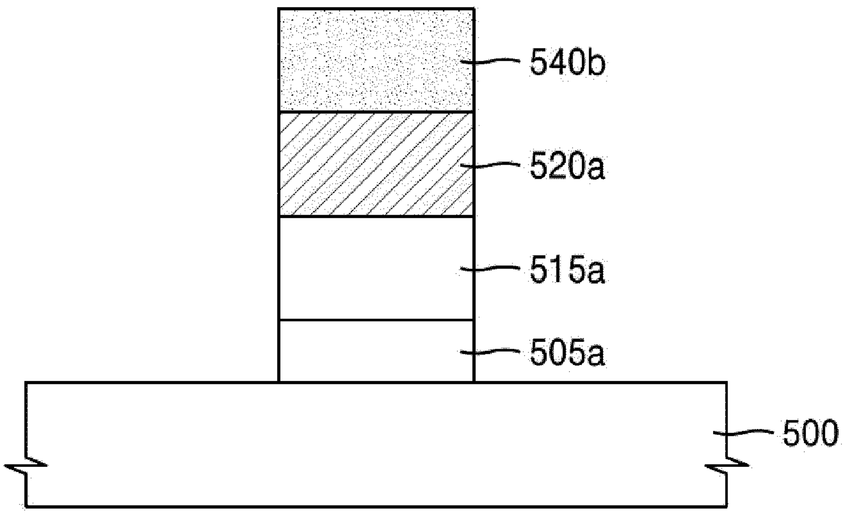

# FIG. 5D

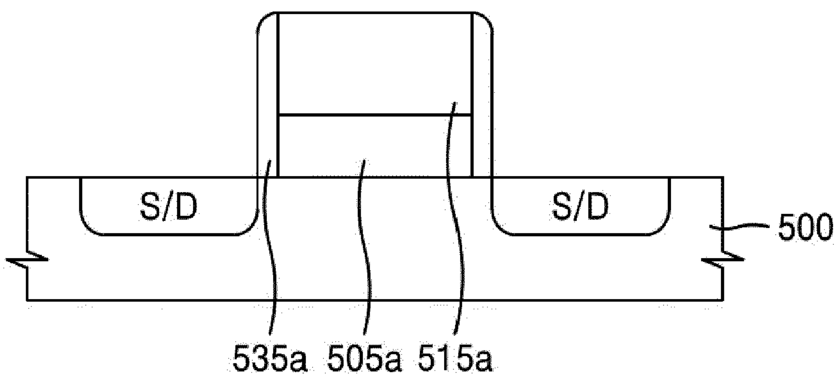

# FIG. 5E

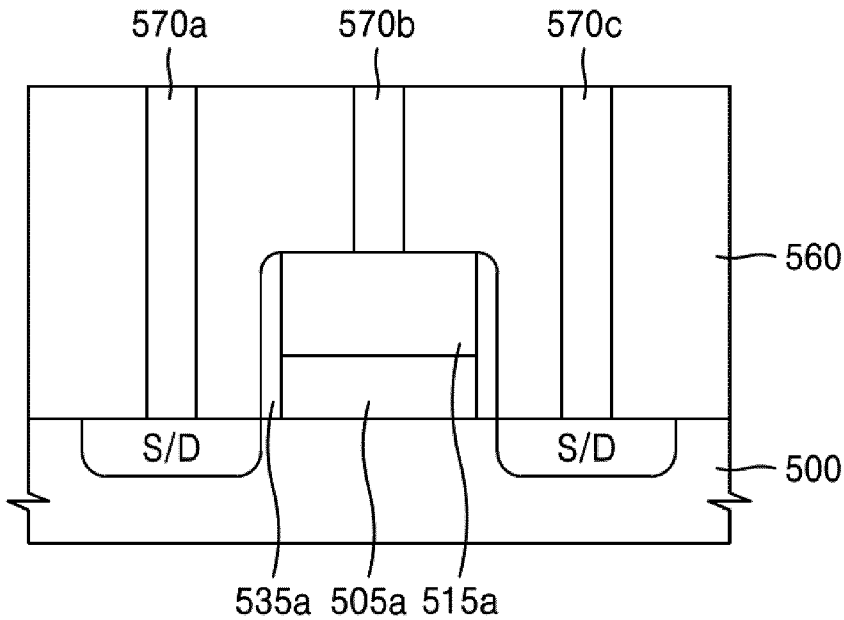

Europäisches Patentamt
European Patent Office
Office européen des brevets

# EUROPEAN SEARCH REPORT

Application Number
EP 24 16 4779

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2018/210338 A1 (YAHAGI MASAHITO [JP] ET AL) 26 July 2018 (2018-07-26)<br>* paragraphs [0833] - [0838]; tables 1, 3-5 *<br>* page 20 * | 1-4, 12-15<br>5-11 | INV.<br>G03F7/004<br>G03F7/039 |
| X | US 6 200 716 B1 (FULLER TIMOTHY J [US] ET AL) 13 March 2001 (2001-03-13)<br>* example 7 * | 1-4 | |
| X | US 9 170 493 B2 (JSR CORP [JP]) 27 October 2015 (2015-10-27)<br>* example 1 * | 1-4 | |
| Y | JP 2017 125200 A (ROHM & HAAS ELECT MAT) 20 July 2017 (2017-07-20)<br>* example 6 * | 5-11 | |

TECHNICAL FIELDS SEARCHED (IPC)

G03F
G03G
C09J

The present search report has been drawn up for all claims

1

| Place of search | Date of completion of the search | Examiner |
|---|---|---|
| The Hague | 27 August 2024 | Jegou, Gwénaëlle |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 24 16 4779

This annex lists the patent family members relating to the patent documents cited in the above-mentioned European search report.
The members are as contained in the European Patent Office EDP file on
The European Patent Office is in no way liable for these particulars which are merely given for the purpose of information.

27-08-2024

| Patent document cited in search report | Publication date | Patent family member(s) | Publication date |
|---|---|---|---|
| US 2018210338 A1 | 26-07-2018 | KR 20180087855 A | 02-08-2018 |
| | | TW 201841954 A | 01-12-2018 |
| | | US 2018210338 A1 | 26-07-2018 |
| US 6200716 B1 | 13-03-2001 | NONE | |
| US 9170493 B2 | 27-10-2015 | JP 5874722 B2 | 02-03-2016 |
| | | JP WO2012117948 A1 | 07-07-2014 |
| | | KR 20140006923 A | 16-01-2014 |
| | | TW 201239537 A | 01-10-2012 |
| | | US 2013341304 A1 | 26-12-2013 |
| | | WO 2012117948 A1 | 07-09-2012 |
| JP 2017125200 A | 20-07-2017 | CN 103121951 A | 29-05-2013 |
| | | JP 2013127052 A | 27-06-2013 |
| | | JP 2017125200 A | 20-07-2017 |
| | | KR 20130049166 A | 13-05-2013 |
| | | TW 201333047 A | 16-08-2013 |
| | | US 2013302735 A1 | 14-11-2013 |

EPO FORM P0459

For more details about this annex : see Official Journal of the European Patent Office, No. 12/82